(19) Europäisches Patentamt
European Patent Office
Office européen des brevets

(11) **EP 2 469 271 A1**

(12) **EUROPEAN PATENT APPLICATION**

(43) Date of publication:
**27.06.2012 Bulletin 2012/26**

(51) Int Cl.:
*G01N 27/04* (2006.01) *G01R 31/26* (2006.01)
*H01L 21/66* (2006.01)

(21) Application number: **10196137.3**

(22) Date of filing: **21.12.2010**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Capres A/S**
**2800 Lyngby (DK)**

(72) Inventors:
• **Wang, Fei**
**DK-2860 Soborg (DK)**

• **Petersen, Dirch Hjorth**
**DK-2870 Dyssegard (DK)**
• **Hansen, Ole**
**DK-2970 Horsholm (DK)**

(74) Representative: **Nielsen, Henrik Sten**
**Budde Schou A/S**
**Vester Søgade 10**
**1601 Copenhagen V (DK)**

(54) **Single-position Hall effect measurements**

(57)    A method for determining a distance between a first position on and an electrical boundary (34) of a test sample (30) by a multi-point probe comprising four contact elements, comprising: contacting the test sample with the four contact elements (10,12,14,15) at the first position, applying a magnetic field (38) at the first position, performing a first and a second four-point measurement and deriving a first and a second resistance value, calculating a first resistance difference from the first and second resistance values, performing a third and a fourth four-point measurement and deriving a third and a fourth resistance value, calculating a second resistance difference from the third and fourth resistance values, defining a first relation including parameters representing the first resistance difference, the second resistance difference, and the distance between the first position and the electrical boundary, determining the distance by using the first and the second resistance differences in the first relation.

FIG. 1

**Description**

In semiconductor processing, it has become more and more important and also difficult to characterize material properties along with the continuous down-scaling of the critical dimensions. Sheet materials such as ultra-shallow junctions are widely used, and sheet resistance measurement has been developed for the study of these. In addition to the sheet resistance of film materials, the sheet carrier density and the mobility are also important properties for the performance of semiconductor device, e.g. in complementary metal-oxide-semiconductor (CMOS) transistors. However, most of the present measurement methods for determining the sheet resistance, the sheet carrier density, and the sheet carrier mobility require either special sample preparation or destructive machining of the sample. Some measurement methods also require several engagements between a probe and a test sample, which impairs the efficiency of the methods.

In order to characterize the sheet carrier density and the mobility of sheet materials, a fast, cheap, and non-destructive method is therefore desired. There are several methods employing microscopic multi-point probes produced by silicon-based micro-fabrication technology that can be used for the sheet resistance measurements. In WO2007045246A1 it has been shown that Hall effect measurement can be made with an in-line micro four-point probe to measure the sheet resistance, the sheet carrier density, and the Hall mobility. However, the method demands two measurement points, i.e. two different engagements between probe and test sample, which can cause large measurement errors when the electrical property is not ideally homogeneous across the sample under test.

It is an object of the present invention to improve the accuracy and reduce the time of determining an electrical property of a test sample. In particular, it is an object of the present invention to improve the accuracy and reduce the time of determining an electrical property that depends on the distance to an electrical boundary of the test sample. According to the present invention, only one measurement point, i.e. one engagement between probe and test sample, is necessary in a Hall effect measurement. This will reduce the measuring time significantly and provide more accurate results for electrical transport properties of thin films.

The object of the invention is achieved according to a first aspect of the invention by a method for determining a distance between a first position on an electrically conducting surface portion of a test sample and an electrical boundary of the electrically conducting surface portion by a multi-point probe comprising a first contact element, a second contact element, a third contact element, and a fourth contact element, each contact element defining a contact point for establishing an electrical contact with the test sample, the method comprising: (i) contacting the test sample with the first contact element, the second contact element, the third contact element, and the fourth contact element at the first position on the electrically conducting surface portion, contacting the test sample with the first contact element, the second contact element, the third contact element, and the fourth contact element at a first position on the electrically conducting surface portion, (ii) applying a magnetic field having a major field component perpendicular to the electrically conducting surface portion at the first position, (iii) applying a first electrical potential across the first and third contact elements for generating a first current in the surface portion at the first position, (iv) measuring the first current through the first or the third contact element, (v) measuring a first voltage across the second and fourth contact elements, and (vi) calculating a first resistance value ($R_B$) based on the first current and the first voltage. The method further comprises: (vii) applying a second electrical potential across the second and fourth contact elements for generating a second current in the surface portion at the first position, (viii) measuring the second current through the second or the fourth contact element, (ix) measuring a second voltage across the first and third contact elements, (x) calculating a second resistance value ($R_B$) based on the second current and the second voltage, and (xi) calculating a first resistance difference ($\Delta R_{BB'}$) based on the difference between the first resistance value and the second resistance value. The method further comprises: (xii) applying a third electrical potential across the first and second contact elements for generating a third current in the surface portion at the first position, (xiii) measuring the third current through the first or the second contact element, (xiv) measuring a third voltage across the third and fourth contact elements, and (xv) calculating a third resistance value ($R_C$) based on the third current and the third voltage. The method further comprises: (xvi) applying a fourth electrical potential across the third and fourth contact elements for generating a fourth current in the surface portion at the first position, (xvii) measuring the fourth current through the third or the fourth contact element, (xviii) measuring a fourth voltage across the first and second contact elements, (xix) calculating a fourth resistance value ($R_{C'}$) based on the fourth current and the fourth voltage, (xx) calculating a second resistance difference ($\Delta R_{CC'}$) based on the difference between the third resistance value and the fourth resistance value, (xxi) defining a first relation (f) including a first, a second, and a third parameter representing the first resistance difference, the second resistance difference, and the distance between the first position and the electrical boundary, respectively, and (xxii) determining the distance (y) between the first position and the electrical boundary by using the first and the second resistance differences ($\Delta R_{BB'}$, $\Delta R_{CC'}$) as the first and the second parameter, respectively, in the first relation.

According to this method, only a single engagement is necessary between the probe and the test sample for accurately determining the distance.

An electrical boundary is to be understood as a boundary preventing a current from leaving the electrically conducting surface portion. Relation is here meant to encompass a single equation, a set of equations, a function, a set of functions, or any appropriate mathematical model of the setup used in the method that involves the specified parameters. The determining of the distance may encompass equation solving, regression analysis, comparisons with modelled or calibrated parameters, or any other mathematical technique appropriate for the specified relation.

The multi-point probe may have any number of contact elements equal to or greater than four, e.g. the multi-point probe may have twelve contact elements. However, four contact elements are employed independent on the total number of contact elements. A contact elements that is not used in the method may be positioned between two contact elements that are used in the method. The multi-point probe may be a probe described in any of WO2010115771A1, WO2010000265A1, WO2008110174A1, WO2007051471A1, WO05124371A1, or WO0003252A2. The contact elements may be in the form of cantilevers that extend from a probe body, e.g. as is shown in WO0003252A2. The test sample may be silicon wafer with a doped surface portion or a thin metal film defining the electrically conductive surface portion. The electrical boundary may be defined by a portion of the physical boundary of the electrically conductive surface portion, with a non-conducting region outside the boundary. Alternatively, the electrical boundary may be defined by a portion of the physical boundary of the test sample as a whole, provided the electrically conductive surface portion extends to the physical boundary.

The magnetic field may be generated by an electromagnet or a permanent magnet positioned on the opposite side of the test sample from the electrically conducting surface portion. The first, second, third, and fourth contact elements may be coupled to a multiplexer, which in turn is coupled to a current source for generating an electrical potential across two of the contact elements, an ammeter for measuring a current through the contact elements, and a voltmeter for measuring the voltage across two of the contact elements. A control unit may be coupled to the multiplexer to automatically control the multiplexer such that the currents can be generated and measured, and the voltages measured, as specified in the method.

The contact points may define a first line intersecting each of the contact points, i.e. the contact points are on a common line.

The electrical boundary may have an approximately linear portion and the distance between the first position and a point on the linear portion may be smaller than the distance between the first position and any point on the electrical boundary outside the linear portion. This means that the shortest distance from the first position to the electrical boundary is to a point on the linear portion.

The method according to the first aspect of the present invention may further comprise: (xxxiv) orienting the multi-point probe to position the first line in a parallel relationship with the linear portion. The spacing between the contact points of the first and second contact elements, the second and third contact elements, and the third and fourth contact elements may be approximately equal.

The first relation may be equivalent to $\Delta R_{CC'}/\Delta R_{BB'} = f(y,s)$, where $\Delta R_{BB'}$ represents the first resistance difference, $\Delta R_{CC'}$ represents the second resistance difference, and f is a function including the distance y between the first position and the electrical boundary and the spacing s between the contact points as parameters.

The first resistance difference $\Delta R_{BB'}$ in the relation $\Delta R_{CC'}/\Delta R_{BB'} = f(y,s)$ may be equivalent to $\Delta R_{BB'} = 2R_H/\pi *$ (arctan($a/2y$) + arctan(b/2y) + arctan($c/2y$) - arctan(($a+b+c$)/2y)) where $\Delta R_{BB'}$ represents the additional first difference ($\Delta R_{BB'}$), $y$ represents the distance ($y$), a represents the spacing between the contact points of the first and second contact elements, b represents the spacing between the contact points of the second and third contact elements, and c represents the spacing between the contact points of the third and fourth contact elements; and the second resistance difference $\Delta R_{CC'}$ in the relation $\Delta R_{CC'}/AR_{BB'} = f(y,s)$ may be equivalent to $\Delta R_{CC'} = 2R_H/\pi*$(arctan(($a+b+c$)/2y) + arctan(b/2y) - arctan(($a+b$)/2y) - arctan(($b+c$)/2y)) where $\Delta R_{CC'}$ represents the additional second difference ($\Delta R_{CC'}$), y represents the distance ($y$), a represents the spacing between the contact points of the first and second contact elements, b represents the spacing between the contact points of the second and third contact elements, and c represents the spacing between the contact points of the third and fourth contact elements.

The method according to the first aspect of the present invention may further comprise: (xxiii) applying a fifth electrical potential across the first and fourth contact elements for generating a fifth current in the surface portion at the first position, (xxiv) measuring the fifth current through the first or the fourth contact element, (xxv) measuring a fifth voltage across the second and third contact elements, (xxvi) calculating a fifth resistance value ($R_A$) based on the fifth current and the fifth voltage, (xxvii) applying a sixth electrical potential across the second and third contact elements for generating a sixth current in the surface portion at the first position, (xxviii) measuring the sixth current through the second or the third contact element, (xxix) measuring a sixth voltage across the first and fourth contact elements, (xxx) calculating a sixth resistance value ($R_A$) based on the sixth current and the sixth voltage, (xxxi) calculating a third resistance difference ($\Delta R_{AA'}$) based on the difference between the fifth resistance value and the sixth resistance value, (xxxii) in defining the first relation (f) the first relation (f) further includes a fourth parameter representing the third resistance difference ($\Delta R_{AA'}$), and (xxxiii) in determining the distance ($y$) between the first position and the electrical boundary, the third resistance difference ($\Delta R_{AA'}$) is used as the fourth parameter in the first relation in addition to the first and the second resistance differences ($\Delta R_{BB'}$, $\Delta R_{CC'}$) being used as the first and the second parameter, respectively.

This allows for the accurate measurements of the distance y with asymmetric probe that have non-equidistant contact points.

The contact points may be positioned in-line and the spacing between the contact points of the third and fourth contact elements may be different from the spacing between the contact points of the first and second contact. The contact points may be positioned in-line and the spacing between the contact points of the first and second contact elements and the spacing between the contact points of the second and third contact elements may be approximately equal. It has been found in simulations that this particular relative spacing of the contact probes gives accurate determinations of the distance to the electrical boundary.

The spacing between the contact points of the third and fourth contact elements may be greater than the spacing between the contact points of the first and second contact elements by a factor in one or more of the ranges 1.1-3.7, 1.2-3.3, 1.3-2.9, 1.4-2.5, 1.5-2.1, and 1.6-1.7, and/or in one of the ranges 1.2-1.3, 1.3-1.4, 1.4-1.5, 1.5-1.6, 1.6-1.7, 1.7-1.8, 1.8-1.9, 1.9-2.0, 2.0-2.2, 2.2-2.4, 2.4-2.6, 2.6-2.8, 2.8-3.0, 3.0-3.3, 3.3-3.6, 3.6-3.9, and/or approximately five divided by three, or by a factor in one or more of the ranges 1.2-3.8, 1.6-3.4, 1.8-3.2, 2.0-3.0, 2.2-2.8, and 2.4-2.6, and/or in one of the ranges 1.2-1.3, 1.3-1.4, 1.4-1.5, 1.5-1.6, 1.6-1.7, 1.7-1.8, 1.8-1.9, 1.9-2.0, 2.0-2.2, 2.2-2.4, 2.4-2.6, 2.6-2.8, 2.8-3.0, 3.0-3.3, 3.3-3.6, 3.6-3.9, and/or approximately five divided by two. It has been found in simulations that these particular relations give accurate determinations of the distance to the electrical boundary,

The spacing between the contact points of the first and second contact elements may be in one of the ranges 1-5 $\mu$m, 5-10 $\mu$m, 10-15 $\mu$m, 15-20 $\mu$m, 20-25 $\mu$m, 25-30 $\mu$m, 30-40 $\mu$m, 40-50 $\mu$m, 50-500 $\mu$m, and/or in one or more of the ranges 1-50 $\mu$m, 5-40 $\mu$m, 10-30 $\mu$m, 15-25 $\mu$m.

The first relation may be equivalent to $(\Delta R_{AA'} + \alpha\Delta R_{CC'})/\Delta R_{BB'} = f(y,a,b,c)$, where $\Delta R_{BB'}$ is the first resistance difference, $\Delta R_{CC'}$ is the second resistance difference, $\Delta R_{AA'}$ is the third resistance difference, $\alpha$ is a tuning factor in the range -10 to 10; and f is a function including the distance y between the first position and the electrical boundary and a the spacing between the contact points of the first and second contact elements, b the spacing between the contact points of the second and third contact elements, and c the spacing between the contact points of the third and fourth contact elements. Further, the tuning factor $\alpha$ may be approximately 1 or approximately -1.

The first resistance difference $\Delta R_{BB'}$ in the relation $(\Delta R_{AA'} + \alpha\Delta R_{CC'})/\Delta R_{BB'} - f(y,a,b,c)$ may be equivalent to $\Delta R_{BB'} = 2R_H/\pi^*(\arctan(a/2y) + \arctan(b/2y) + \arctan(c/2y) - \arctan((a+b+c)/2y))$ where $\Delta R_{BB'}$ represents the additional first difference ($\Delta R_{BB'}$), y represents the distance (y), a represents the spacing between the contact points of the first and second contact elements, b represents the spacing between the contact points of the second and third contact elements, and c represents the spacing between the contact points of the third and fourth contact elements; the second resistance difference $\Delta R_{CC'}$ in the relation $(\Delta R_{AA'} + \alpha\Delta R_{CC'})/\Delta R_{BB'} = f(y,a,b,c)$ may be equivalent to $\Delta R_{CC'} = 2R_H/\pi^*$ $(\arctan((a+b+c)/2y) + \arctan(b/2y) - \arctan((a+b)/2y) - \arctan((b+c)/2y))$ where $\Delta R_{CC'}$ represents the additional second difference ($\Delta R_{CC'}$), y represents the distance (y), a represents the spacing between the contact points of the first and second contact elements, b represents the spacing between the contact points of the second and third contact elements, and c represents the spacing between the contact points of the third and fourth contact elements; and the third resistance difference $\Delta R_{AA'}$ in the relation $(\Delta R_{AA'} + \alpha\Delta R_{CC'})/\Delta R_{BB'} = f(,y,a,b,c)$ may be equivalent to $\Delta R_{AA'} = 2R_H/\pi^*(\arctan((a+b)/2y) - \arctan(a/2y) - \arctan((b+c)/2y) + \arctan(c/2y))$ where $\Delta R_{AA'}$, represents the additional third resistance difference ($\Delta R_{AA'}$), y represents the distance (y), a represents the spacing between the contact points of the first and second contact elements, b represents the spacing between the contact points of the second and third contact elements, and c represents the spacing between the contact points of the third and fourth contact elements. It has been found that this particular modelling gives accurate results over a wide range of measurement conditions.

The spacing between the contact points of the first and second contact elements may be in one or more of the ranges 0.1-100 $\mu$m, 1-90 $\mu$m, 10-80 $\mu$m, 20-70 $\mu$m, 30-60 $\mu$m, and 40-50 $\mu$m; and/or in one of the ranges 0.1-1 $\mu$m, 1-10 $\mu$m, 10-20 $\mu$m, 20-30 $\mu$m, 30-40 $\mu$m, 40-50 $\mu$m, 50-60 $\mu$m, 60-70 $\mu$m, 70-80 $\mu$m, 80-90 $\mu$m, 90-100 $\mu$m, or 100-500 $\mu$m.

The object of the invention is achieved according to a second aspect of the invention by a method for determining an electrical property at a first position on an electrically conducting surface portion of a test sample, the electrically conducting surface portion having an electrical boundary and the method comprising: (a) determining a distance (y) between the first position on the electrically conducting surface portion of the test sample and the electrical boundary of the electrically conducting surface portion according to the first aspect of the present invention, (b) defining a second relation including the electrical property and a fifth parameter representing the distance (y), and (c) determining the electrical property from the second relation by using the distance (y) as the fifth parameter.

According to this method, only a single engagement is necessary between the probe and the test sample for accurately determining the electrical property.

An electrical boundary is to be understood as a boundary preventing a current from leaving the electrically conducting surface portion. Relation is here meant to encompass a single equation, a set of equations, a function, a set of functions, or any appropriate mathematical model of the setup used in the method that involves the specified parameters. The determining of the electrical property may encompass equation solving, regression analysis, comparisons with modelled or calibrated parameters, or any other mathematical technique appropriate for the specified relation,

The second relation may further include the spacing between the contact points of the first contact element, the second contact element, the third contact element, and/or the fourth contact element, and: (b') in defining the second relation the second relation further incudes a ninth parameter representing the spacing between the contact points of the first contact element, the second contact element, the third contact element, and/or the fourth contact element, and (c') in determining the electrical property, the spacing is used as the ninth parameter in the second relation in addition to the first distance ($y$).

The electrical property may be the Hall sheet resistance ($R_H$) and the second relation ($f_1,f_2$) may further include a sixth parameter representing an additional first resistance difference ($\Delta R_{BB'}$), the method may further comprise: (d) applying an additional first electrical potential across the first and third contact elements for generating an additional first current in the surface portion at the first position, (e) measuring the additional first current through the first or the third contact element, (f) measuring an additional first voltage across the second and fourth contact elements, (g) calculating an additional first resistance value ($R_B$) based on the additional first current and the additional first voltage, or (g') retaining the first resistance value ($R_B$) from the determining of the distance as an additional first resistance value ($R_B$). The method may further comprise: (h) applying an additional second electrical potential across the second and fourth contact elements for generating an additional second current in the surface portion at the first position, (i) measuring the additional second current through the second or the fourth contact element, (j) measuring an additional second voltage across the first and third contact elements, (k) calculating an additional second resistance value ($R_{B'}$) based on the additional second current and the additional second voltage, or (k') retaining the second resistance value ($R_{B'}$) from the determining of the distance as an additional second resistance value ($R'_B$), and (l) calculating the additional first resistance difference ($\Delta R_{BB'}$) based on the difference between the additional first resistance value and the additional second resistance value, or (l') retaining the first resistance difference ($\Delta R_{BB'}$) from the determining of the distance as the additional first resistance difference ($\Delta R_{BB'}$).

The second relation may be equivalent to $\Delta R_{BB'} = 2R_H/\pi * (\arctan(a/2y) + \arctan(b/2y) + \arctan(c/2y) - \arctan((a+b+c)/2y))$ where $\Delta R_{BB'}$ represents the additional first difference ($\Delta R_{BB'}$), $y$ represents the distance ($y$), a represents the spacing between the contact points of the first and second contact elements, $b$ represents the spacing between the contact points of the second and third contact elements, and c represents the spacing between the contact points of the third and fourth contact elements.

The electrical property may be the Hall sheet resistance ($R_H$) and the second relation ($f_2,f_3$) may further include a sixth parameter representing an additional second resistance difference ($\Delta R_{CC'}$), The method may further comprise: (d) applying an additional third electrical potential across the first and second contact elements for generating an additional third current in the surface portion at the first position, (e) measuring the additional third current through the first or the second contact element, (f) measuring an additional third voltage across the third and fourth contact elements, (g) calculating an additional third resistance value ($R_C$) based on the additional third current and the additional third voltage, or (g') retaining the second resistance value ($R_C$) from the determining of the distance as an additional first resistance value ($R_C$). The method may further comprise: (h) applying an additional fourth electrical potential across the third and fourth contact elements for generating an additional fourth current in the surface portion at the first position, (i) measuring the additional fourth current through the third or the fourth contact element, (j) measuring an additional fourth voltage across the first and second contact elements, (k) calculating an additional fourth resistance value ($R_{C'}$) based on the additional fourth current and the additional fourth voltage, or (k') retaining the second resistance value ($R_{C'}$) from the determining of the distance as an additional first resistance value ($R_{C'}$), and (l) calculating the additional second resistance difference ($\Delta R_{CC'}$) based on the difference between the additional third resistance value and the additional forth resistance value, or (l') retaining the second resistance difference ($\Delta R_{CC'}$ from the determining of the distance as the additional second resistance difference ($\Delta R_{CC'}$).

The second relation may be equivalent to $\Delta R_{CC'} = 2R_H/\pi * (\arctan((a+b+c)/2y) + \arctan(b/2y) - \arctan((a+b)/2y) - \arctan((b+c)/2y))$ where $\Delta R_{CC'}$ represents the additional second difference ($\Delta R_{CC'}$), $y$ represents the distance ($y$), a represents the spacing between the contact points of the first and second contact elements, $b$ represents the spacing between the contact points of the second and third contact elements, and $c$ represents the spacing between the contact points of the third and fourth contact elements.

The electrical property may be the Hall sheet resistance ($R_H$) and the second relation ($f_1$) may further includes a sixth parameter representing an additional third resistance difference ($\Delta R_{AA'}$). The method may further comprise: (d) applying an additional fifth electrical potential across the first and fourth contact elements for generating an additional fifth current in the surface portion at the first position, (e) measuring the additional fifth current through the first or the fourth contact element, (f) measuring an additional fifth voltage across the second and third contact elements, (g) calculating an additional fifth resistance value ($R_A$) based on the additional fifth current and the additional fifth voltage, or (g') retaining the fifth resistance value ($R_A$) from the determining of the distance as an additional fifth resistance value ($R_A$) The method may further comprise: (h) applying an additional sixth electrical potential across the second and third contact elements for generating an additional sixth current in the surface portion at the first position, (i) measuring the additional sixth current through the second or the third contact element, (j) measuring an additional sixth voltage across the first and fourth contact elements, (k) calculating an additional sixth resistance value ($R_{A'}$) based on the additional sixth current and the additional sixth voltage, or (k') retaining the sixth resistance value ($R_{A'}$) from the determining of the distance as an additional fifth resistance value ($R_{A'}$), and (l) calculating the additional third resistance difference ($\Delta R_{AA'}$) based on the difference between the additional fifth resistance value and the additional sixth resistance value, or (l') retaining the third resistance difference ($\Delta R_{AA'}$) from the determining of the distance as the additional third resistance difference ($\Delta R_{AA'}$). The second relation may be equivalent to $\Delta R_{AA'} = 2R_H/\pi^* (\arctan((a+b)/2y) - \arctan(a/2y) - \arctan((b+c)/2y) + \arctan(c/2y))$ where $\Delta R_{AA'}$ represents the additional third resistance difference ($\Delta R_{AA'}$), $y$ represents the distance ($y$), $a$ represents the spacing between the contact points of the first and second contact elements, $b$ represents the spacing between the contact points of the second and third contact elements, and $c$ represents the spacing between the contact points of the third and fourth contact elements.

The electrical property may be the sheet resistance ($R_0$) and the second relation ($g$) may further include a sixth parameter representing a pseudo sheet resistance ($R_P$). The method may further comprise: (d) applying an additional fifth electrical potential across the first and fourth contact elements for generating an additional fifth current in the surface portion at the first position, (e) measuring the additional fifth current through the first or the fourth contact element, (f) measuring an additional fifth voltage across the second and third contact elements, (g) calculating an additional fifth resistance value ($R_A$) based on the additional fifth current and the additional fifth voltage, or (g') retaining the fifth resistance value ($R_A$) from the determining of the distance as an additional fifth resistance value ($R_A$). The method may further comprise: (h) applying an additional sixth electrical potential across the second and third contact elements for generating an additional sixth current in the surface portion at the first position, (i) measuring the additional sixth current through the second or the third contact element, (j) measuring an additional sixth voltage across the first and fourth contact elements, (k) calculating an additional sixth resistance value ($R_{A'}$) based on the additional sixth current and the additional sixth voltage, or (k') retaining the sixth resistance value ($R_{A'}$) from the determining of the distance as an additional fifth resistance value ($R_{A'}$), and (l) calculating a first resistance mean ($\overline{R_{AA'}}$) of the additional fifth resistance value ($R_A$) and the additional sixth resistance value ($R_{A'}$). The method may further comprise: (d") applying an additional first electrical potential across the first and third contact elements for generating an additional first current in the surface portion at the first position, (e") measuring the additional first current through the first or the third contact element, (f") measuring an additional first voltage across the second and fourth contact elements, (g") calculating an additional first resistance value ($R_B$) based on the additional first current and the additional first voltage, or (g''') retaining the first resistance value ($R_B$) from the determining of the distance as an additional first resistance value ($R_B$). The method may further comprise: (h") applying an additional second electrical potential across the second and fourth contact elements for generating an additional second current in the surface portion at the first position, (i") measuring the additional second current through the second or the fourth contact element, (j") measuring an additional second voltage across the first and third contact elements, (k") calculating an additional second resistance value ($R_{B'}$) based on the additional second current and the additional second voltage, or (k''') retaining the second resistance value ($R_B$) from the determining of the distance as an additional second resistance value ($R'_B$), and (l") calculating a second resistance mean ($\overline{R_{BB'}}$) of the additional first resistance value ($R_B$) and the additional second resistance value ($R_{B'}$), and (m) defining a third relation including a seventh, eighth, and ninth parameter representing the first resistance mean ($\overline{R_{AA'}}$), the second resistance mean ($\overline{R_{BB'}}$), and the pseudo sheet resistance ($R_P$), respectively, (n) determining the pseudo sheet resistance ($R_P$) by using the first resistance mean ($\overline{R_{BB'}}$) and the second resistance mean ($\overline{R_{BB'}}$) as the seventh parameter and the eighth parameter, respectively, in the third relation.

The third relation may be equivalent to $\exp(2\pi \cdot \overline{R_{BB'}}/R_P) - \exp(2\pi \cdot \overline{R_{BB'}}/R_P) = 1$, where $R_P$ is the pseudo sheet resistance, $R_{BB'}$ is the first resistance mean, and $R_{BB'}$ is the second resistance mean.

The Hall sheet carrier density $N_{HS}$ may be calculated as: $N_{HS} = B/(ZeR_H)$, where B is the magnetic field component perpendicular to the electrically conducting surface portion, $Ze$ is the carrier charge ($Z = \pm 1$), and $R_H$ the Hall sheet resistance. The mean Hall carrier mobility $\mu_H$ may be calculated as: $\mu_H = (ZR_H)/(R_0B)$, where $Z = \pm 1$ depending on the type of carrier charge, $R_H$ the Hall sheet resistance, $R_0$ the sheet resistance, and $B$ is the magnetic field component perpendicular to the electrically conducting surface portion. If the magnetic field is generated by an electromagnet, the magnetic field component $B$ may be calculated theoretically from the current through the electromagnet. If the magnetic field is generated by a permanent magnet, the magnetic field component B may be pre-determined by a suitable calibration.

The object of the invention is achieved according to a third aspect of the invention by an apparatus for determining a distance between a first position on an electrically conducting surface portion of a test sample and an electrical boundary of the electrically conducting surface portion, the apparatus comprising: a multi-point probe comprising a first contact element, a second contact element, a third contact element, and a fourth contact element, each contact element defining a contact point for establishing an electrical contact with the test sample; and a control unit adapted for performing the method for determining a distance according to the first aspect of the present invention with said multi-point probe.

The object of the invention is achieved according to a fourth aspect of the invention by an apparatus for determining an electrical property at a first position on an electrically conducting surface portion of a test sample comprising: a multi-point probe comprising a first contact element, a second contact element, a third contact element, and a fourth contact element, each contact element defining a contact point for establishing an electrical contact with the test sample; and a control unit adapted for performing the method for determining an electrical property at a first position on an electrically conducting surface portion of a test sample according to the second aspect of the present invention with said multi-point probe.

**Description of Figures**

A number of embodiments of the different aspects of the present invention are described below, where:

FIG.1 illustrates a four-point probe in contact with an electrically conducting surface portion of a test sample,

FIG.2A illustrates the equidistant spacing between the contact points of the contact elements of a probe in a preferred embodiment,

FIG.2B illustrates the asymmetric spacing between the contact points of the contact elements of a probe in an alternative embodiment,

FIG..2C illustrates the asymmetric spacing between the contact points of the contact elements of a probe in another alternative embodiment,

FIGS.3A(1)-(2) illustrate current-source and voltage-measurement configurations of the contact elements according to an alternative embodiment,

FIGS.3B(1)-(2) and FIGS.3C(1)-(2) illustrate current-source and voltage-measurement configurations of the contact elements according to the preferred embodiment,

FIG.4A-C illustrates relations for determining the distance to an electrical boundary, the Hall sheet resistance, and the sheet resistance according to the preferred embodiment, and

FIG.5A-C illustrates relations for determining the distance to an electrical boundary, the Hall sheet resistance, and the sheet resistance according to an alternative embodiment.

**Detailed description**

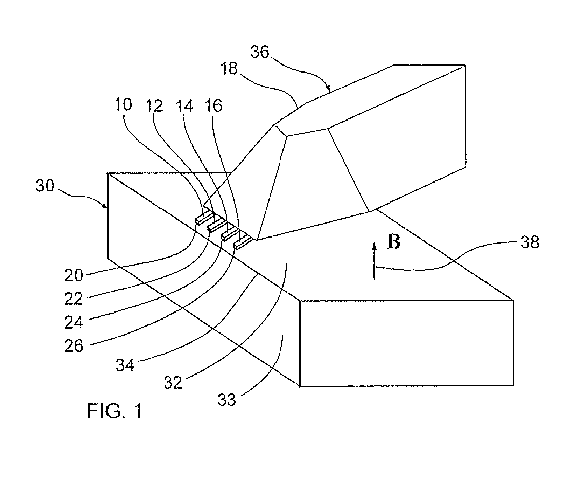

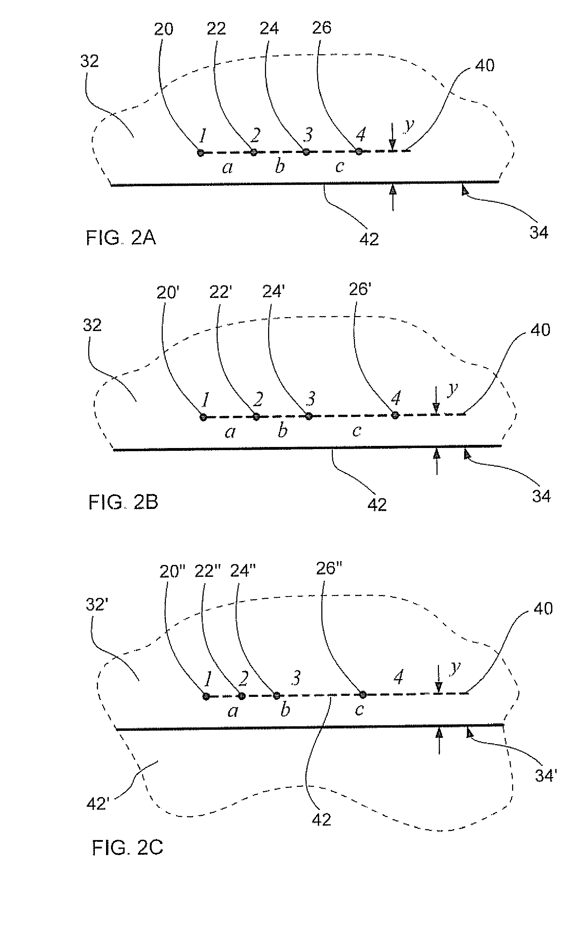

FIG.1 illustrates a multi-point probe 36 contacting a test sample 30. The test sample 30 has an electrically conducting surface portion 32 and a boundary 34 physically defined by the edge between the surface portion 32 corresponding to the top surface of the test sample 30 and the side surface 33 of the test sample 30. The side surface 33 is not electrically conducting and the boundary is therefore an electrical boundary preventing currents from leaving the electrically conducting surface portion 32.
The multi-point probe 36 has a probe body 18 from which a first contact element 10, a second contact element 12, a third contact element 14, and a fourth contact element 16 extend. Each of the contact elements 10-16 is cantilever with one end connected to the probe body 18 and the other end defining a contact point 20-26 The contact points 20-26 of the setup in FIG.1 are in contact with the electrically conducting surface portion 32. The contact elements 10-16 are electrically conducting. Thus, a current can pass through each of the contact elements into the electrically conducting surface portion 32. A constant magnetic field **B** is applied to the test sample 30 such that it has a field component 38 that is perpendicular to the electrically conducting surface portion 32.
The contact points 20-26 of the contact elements 10-16 all lay on a common line 40, as is shown in FIGS.2A-C. The electrical boundary 34 has a linear portion 42 and the contact elements 10-16 are oriented so that the common line 40 is parallel to the linear portion 42. The distance or spacing between the contact points 20-22 of the first and second contact elements is denoted a, the distance or spacing between the contact points 22-24 of the second and third contact elements is denoted b, and the distance or spacing between the contact points 24-26 of the third and fourth contact elements is denoted c. The distance or spacing between the common line 40 and the linear portion 42 is denoted y. In the preferred embodiment shown in FIG.2A the distances a-c between the contact points 20-26 of the contact elements are approximately equal to 21 $\mu$m. In the alternative embodiment shown in FIG.2B the distance a between the contact points 20'-22' of the first and second contact elements is approximately 21 $\mu$m, the distance b between the contact points 22'-24' of the second and third contact elements is approximately 21 $\mu$m, and the distance c between the contact points 24'-26' of the third and fourth contact elements is approximately 35 $\mu$m. In another alternative embodiment shown in FIG.2C the distance a between the contact points 20"-22" of the first and second contact elements is approximately 14 $\mu$m, the distance b between the contact points 22"-24" of the second and third contact elements is approximately 14 $\mu$m, and the distance c between the contact points 24"-26" of the third and fourth contact elements is approximately 35 $\mu$m.

The test sample described in relation to the preferred embodiment of FIG.2A and the test sample described in relation to the alternative embodiment of FIG.2B are the same. In these embodiments the electrical boundary 34 is defined as described in relation to FIG.1. In the alternative embodiment described in relation to FIG.2C the electrical boundary 34' is defined as a transition between an electrically conducting surface portion 32' and an electrically non-conducting surface portion 44 on the top surface of a test sample, which means that the two surface portions 34' 44 are essentially parallel.

Different electrical properties of the electrically conductive surface portion can be determined. In a preferred embodiment the Hall sheet resistance and the sheet resistance are measured with a four-point probe having contact points as shown in FIG.2A.

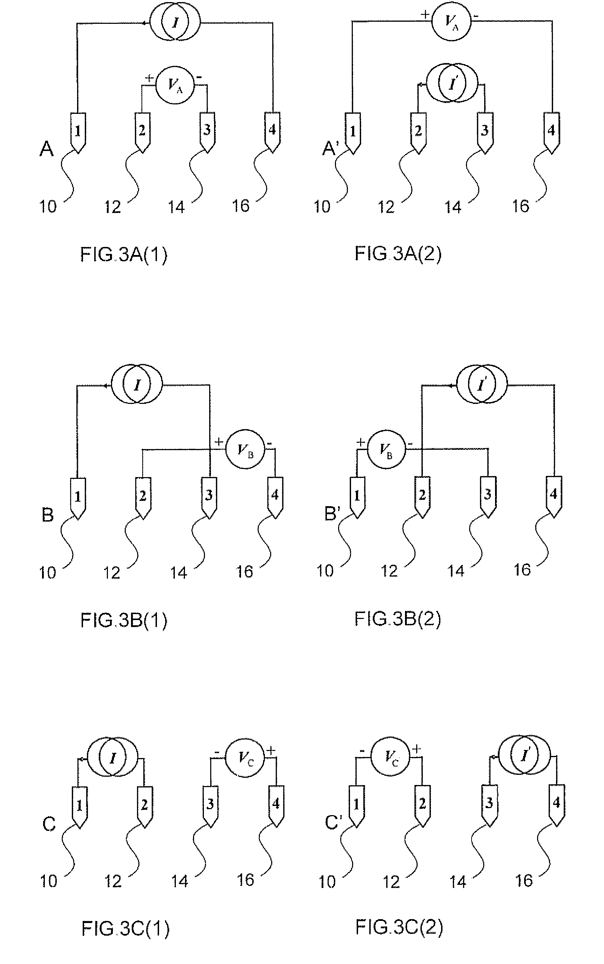

The positioning of the contact points 20-26 defines a first position on the electrically conducting surface portion 32 at a distance $y$ from the electrical boundary 34. An electrical potential is applied across the first 10 and third 14 contact elements such that a current $I$ is injected in the surface portion through the first contact element 10, and at least some of the current is drained through the third contact element 14, as is shown in FIG.3B(1). The current $I$ through the first contact element 10 and the voltage $V_A$ across the second 12 and fourth 16 contact elements are measured, and a first resistance value ($R_B$) is calculated as the voltage $V_A$ divided by the current $I$. Subsequently, an electrical potential is applied across the second 12 and fourth 14 contact elements such that a current $I$ is injected in the surface portion through the second element 12, and at least some of the current is drained through the fourth contact element 14, as is shown in FIG.3B(2). The current $I$ through the second contact element 12 and the voltage $V_{A'}$ across the first 10 and third 14 contact elements are measured, and a second resistance value ($R_{B'}$) is calculated as the voltage $V_{A'}$ divided by the current $I$. A first resistance difference ($\Delta R_{BB'}$) defined as the difference between the first resistance value ($R_B$) and the second resistance value ($R_{B'}$) is then calculated:

$$\Delta R_{BB'} = R_B - R_{B'} \qquad \text{(Eq. 1.1)}$$

as well as the mean ($\overline{R_{BB'}}$) between the third resistance value ($R_B$) and the fourth resistance value ($R_B$):

$$\overline{R_{BB'}} = (R_B + R_{B'})/2 . \qquad \text{(Eq. 1.2)}$$

An electrical potential is applied across the first and second contact elements such that a current $I$ is injected in the surface portion through the first contact element 10, and at least some of the current is drained through the second contact element 12, as is shown in FIG.3C(1). The current $I$ through the first contact 10 element and the voltage $V_C$ across the third 14 and fourth 16 contact elements are measured, and a third resistance value ($R_C$) is calculated as the voltage $V_C$ divided by the current $I$. Subsequently, an electrical potential is applied across the third 14 and fourth 16 contact elements such that a current $I$ is injected in the surface portion through the third element 14, and at least some of the current is drained through the fourth contact element 16, as is shown in FIG.3B(2). The current $I$ through the third contact element 14 and the voltage $V_C$ across the first 10 and second 12 contact elements are measured, and a fourth resistance value ($R_C$) is calculated as the voltage $V_{C'}$ divided by the current $I$. A second resistance difference ($\Delta R_{CC'}$) defined as the difference between the third resistance value ($R_C$) and the fourth resistance value ($R_{C'}$) is then calculated:

$$\Delta R_{CC'} = R_C - R_{C'} \qquad \text{(Eq. 1.3)}$$

as well as the mean ($\overline{R_{CC'}}$) between the third resistance value ($R_C$) and the fourth resistance value ($R_C$):

$$\overline{R_{CC'}} = (R_C + R_{C'})/2, \qquad (Eq.1.4)$$

A number of relations are defined corresponding to a mathematical model of a four-point probe contacting a test sample as shown in FIG.2A.

$$f_1 = \frac{\Delta R_{BB'}}{R_H} = \frac{2}{\pi}\left(3\arctan\frac{s}{2y} - \arctan\frac{3s}{2y}\right), \text{ and} \qquad (Eq.1.5)$$

$$f_2 = -\frac{\Delta R_{CC'}}{R_H} = -\frac{2}{\pi}\left(\arctan\frac{3s}{2y} + \arctan\frac{s}{2y} - 2\arctan\frac{s}{y}\right). \qquad (Eq.1.6)$$

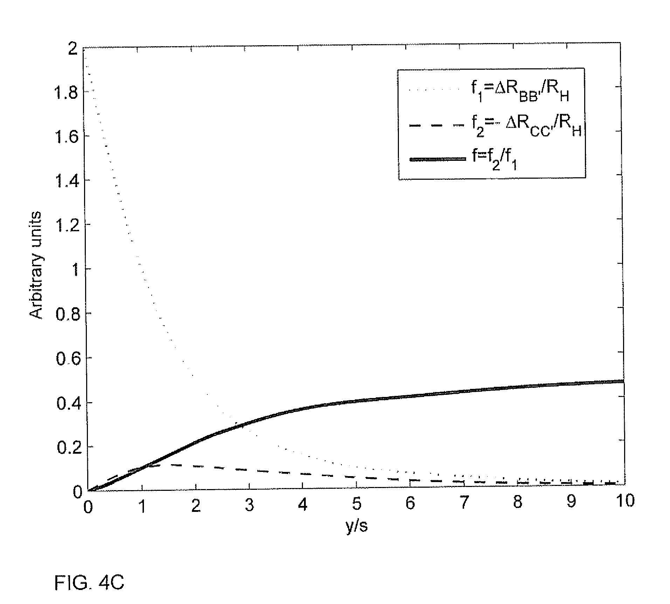

Where s represents the spacing between neighbouring probe arms, which is the same for all pairs of neighbouring probe arms, i.e. $s = a = b = c$, $\Delta R_{BB'}$ represents the first resistance difference, $y$ represents the distance between the contact points 20-26 and the electrical boundary 34, $\Delta R_{CC'}$ represents the second resistance difference, $R_H$ represents the Hall sheet resistance at the first position of the electrically conducting surface portion 32 where contact is established by the four-point probe 36. In FIG.4C the relation $f_1$ (Eq.1.5) is shown as a dotted line and $f_2$ (Eq.1.6) is shown is a dashed line.

The ratio between the two relations above (Eq.1.4 and 1.3) is employed for defining a first relation:

$$f = \frac{f_2}{f_1}, \qquad (Eq.1.7)$$

which can also be written as:

$$\frac{\Delta R_{CC'}}{\Delta R_{BB'}} = f\left(\frac{y}{s}\right), \qquad (Eq.1.8)$$

i.e. the first relation is a function of the distance $y$ normalized with the nominal spacing $s$. This relation (Eq.1.7 and 1.8) is shown as a solid line in the graph of FIG.4C. The measured first ($\Delta R_{BB'}$) and the second ($\Delta R_{CC'}$) resistance differences are then used with the first relation (Eq.1.8) to derive the normalized distance $y/s$. For example, a ratio $\Delta R_{CC'}/\Delta R_{BB}$ of 0.2 would give a normalized distance $y/s$ of approximately 2, and a ratio $\Delta R_{CC'}/\Delta R_{BB}$ of 0.4 would give a normalized distance y/s of approximately 5.5, which can be read from FIG.4C. The nominal spacing s is known and the distance $y$ is therefore readily determined from the normalized distance $y/s$. A normalized distance $y/s$ of 2 would give a value of the function $f_1$ of approximately 0.5, and a normalized distance $y/s$ of 5.5 would give a value of the function $f_1$ of approximately 0.08. The measured first resistance difference ($\Delta R_{BB}$) together with the relation in Eq.1.3 then gives the Hall sheet resistance $R_H$ The function $f_2$ can also be used in a similar fashion.

In order to determine the Sheet resistance of the electrically conductive surface portion, i.e. another electrical property than the Hall sheet resistance, a first resistance mean $\overline{R_{AA}}$ is calculated as the sum of the resistance means $\overline{R_{BB'}}$ and $\overline{R_{CC'}}$ defined by Eqs.1.2 and 1.4:

$$\overline{R_{AA'}} = \overline{R_{BB'}} + \overline{R_{CC'}} \quad (Eq.\,1.9)$$

The pseudo sheet resistance $R_p$ is then determined from the van der Pauw equation:

$$\exp\left(\frac{2\pi\overline{R_{AA'}}}{R_P}\right) - \exp\left(\frac{2\pi\overline{R_{BB'}}}{R_P}\right) = 1 \; , \quad (Eq.\,1.10)$$

A second relation is defined for determining the sheet resistance of the electrically conducting surface potion where it is contacted by the four-point probe, namely:

$$\frac{R_P}{R_0} = g\left(\frac{y}{s}\right) , \quad (Eq.\,1.11)$$

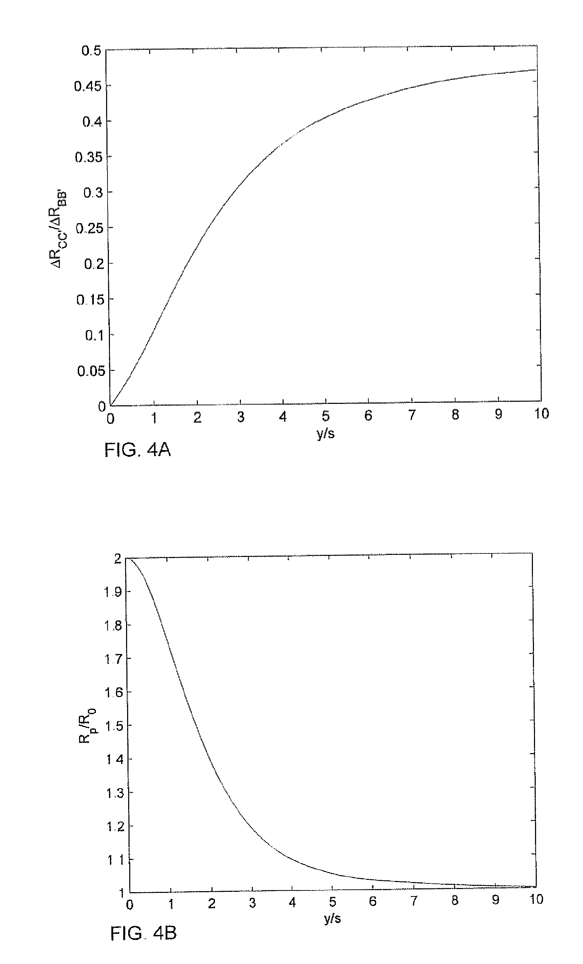

where $R_p$ is the pseudo sheet resistance, $R_0$ the sheet resistance, and $g$ is a function of the normalized distance $y/s$. The function $g$ is geometrical in the sense that it does not depend on the actual size or dimensions of the four-point probe. The function $g$ representing a four-point probe with equidistant contact probes as in FIG.2A is shown in FIG.4B. For example, normalized distance $y/s$ of 2 would give a value of the function g, i.e. the ration $R_p/R_0$, of approximately 1.40, and a normalized distance $y/s$ of 5.5 would give the corresponding value, or ratio, of approximately 1.14. With the pseudo sheet resistance $R_p$ determined as described in relation to Eqs.1.9 and 1.10, the sheet resistance $R_0$ is then readily calculated from Eq.1.11.

In a second embodiment the Hall sheet resistance and the sheet resistance are measured with an asymmetric four-point probe as shown in FIG.2B.

The positioning of the contact points 20'-26' defines a first position on the electrically conducting surface portion 32 at a distance $y$ from the electrical boundary 34. An electrical potential is applied across the first 10 and third 14 contact elements such that a current $I$ is injected in the surface portion through the first contact element 10, and at least some of the current is drained through the third contact element 14, as is shown in FIG.3B(1). The current $I$ through the first contact element 10 and the voltage $V_B$ across the second 12 and fourth 16 contact elements are measured, and a first resistance value ($R_B$) is calculated as the voltage $V_B$ divided by the current. Subsequently, an electrical potential is applied across the second 12 and fourth 14 contact elements such that a current $I$ is injected in the surface portion through the second element 12, and at least some of the current is drained through the fourth contact element 14, as is shown in FIG.3B(2). The current $I$ through the second contact element 12 and the voltage $V_B$ across the first 10 and third 14 contact elements are measured, and a second resistance value ($R_{B'}$) is calculated as the voltage $V_B$ divided by the current $I$. A first resistance difference ($\Delta R_{BB'}$) defined as the difference between the first resistance value ($R_B$) and the second resistance value ($R_{B'}$) is then calculated:

$$\Delta R_{BB'} = R_B - R_{B'} \quad (Eq.\,2.1)$$

as well as the mean ($\overline{R_{BB'}}$) between the third resistance value ($R_B$) and the fourth resistance value ($R_{B'}$):

$$\overline{R_{BB'}} = (R_B + R_{B'})/2 \; . \quad (Eq.\,2.2)$$

An electrical potential is applied across the first and second contact elements such that a current *I* is injected in the surface portion through the first contact element 10, and at least some of the current is drained through the second contact element 12, as is shown in FIG.3C(1). The current *I* through the first contact 10 element and the voltage $V_C$ across the third 14 and fourth 16 contact elements are measured, and a third resistance value ($R_C$) is calculated as the voltage $V_C$ divided by the current *I*. Subsequently, an electrical potential is applied across the third 14 and fourth 16 contact elements such that a current *I* is injected in the surface portion through the third element 14, and at least some of the current is drained through the fourth contact element 16, as is shown in FIG.3B(2). The current I through the third contact element 14 and the voltage $V_{C'}$ across the first 10 and second 12 contact elements are measured, and a fourth resistance value ($R_C$) is calculated as the voltage $V_{C'}$ divided by the current *I*. A second resistance difference ($\Delta R_{CC}$) defined as the difference between the third resistance value ($R_C$) and the fourth resistance value ($R_{C'}$) is then calcualted:

$$\Delta R_{CC'} = R_C - R_{C'},$$ (Eq.2.3)

as well as the mean ($\overline{R_{CC}}$) between the third resistance value ($R_C$) and the fourth resistance value ($R_C$):

$$\overline{R_{CC'}} = (R_C + R_{C'})/2,$$ (Eq.2.4)

An electrical potential is applied across the first 10 and fourth 16 contact elements such that a current *I* is injected in the surface portion through the first contact element 10, and at least some of the current is drained through the fourth contact element 16, as is shown in FIG.3A(1). The current *I* through the first contact element 10 and the voltage $V_A$ across the second 12 and third 14 contact elements are measured, and a fifth resistance value ($R_A$) is calculated as the voltage $V_A$ divided by the current *I*. Subsequently, an electrical potential is applied across the second 12 and third 14 contact elements such that a current *I* is injected in the surface portion through the second element 12, and at least some of the current is drained through the third contact element 14, as is shown in FIG.3A(2). The current *I* through the second contact element 12 and the voltage $V_{A}\cdot$ across the first 10' and fourth 16 contact elements are measured, and a sixth resistance value ($R_A\cdot$) is calculated as the voltage $V_{A'}$, divided by the current *I*. A third resistance difference ($\Delta R_{AA'}$) defined as the difference between the fifth resistance value ($R_A$) and the sixth resistance value ($R_{B'}$) is then calculated:

$$\Delta R_{AA'} = R_A - R_{A'}$$ (Eq.2.5)

as well as the mean ($\overline{R_{AA'}}$) between the fifth resistance value ($R_A$) and the sixth resistance value ($R_A$):

$$\overline{R_{AA'}} = (R_A + R_{A'})/2.$$ (Eq.2.6)

A number of relations are defined corresponding to a mathematical model of a four-point probe contacting a test sample as shown in FIG.2C, namely:

$$f_1 = \frac{\Delta R_{AA'}}{R_{II}} = \frac{2}{\pi}\left(\arctan\frac{a+b}{2y} - \arctan\frac{a}{2y} - \arctan\frac{b+c}{2y} + \arctan\frac{c}{2y}\right),$$ (Eq.2.7)

$$f_2 = \frac{\Delta R_{BB'}}{R_H} = \frac{2}{\pi}\left(\arctan\frac{a}{2y} + \arctan\frac{b}{2y} + \arctan\frac{c}{2y} - \arctan\frac{a+b+c}{2y}\right), \text{ and} \qquad (Eq.2.8)$$

$$f_3 = -\frac{\Delta R_{CC'}}{R_H} = -\frac{2}{\pi}\left(\arctan\frac{a+b+c}{2y} + \arctan\frac{b}{2y} - \arctan\frac{a+b}{2y} - \arctan\frac{b+c}{2y}\right), \qquad (Eq.2.9)$$

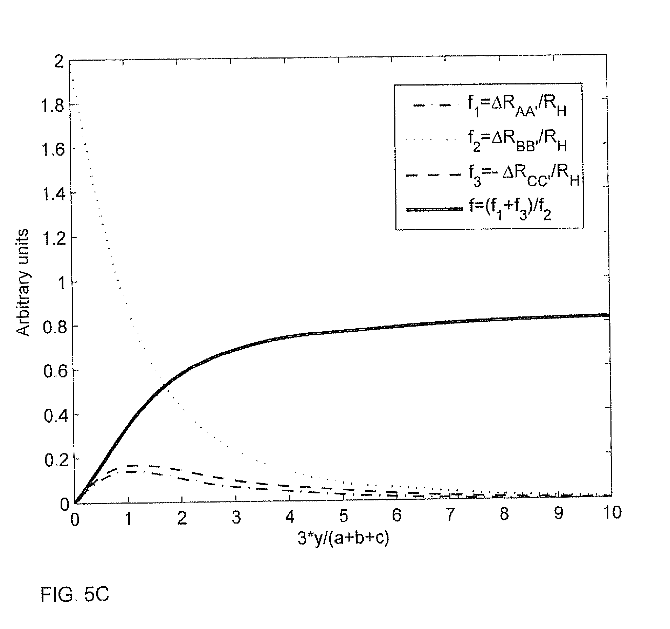

where $a$, $b$, and $c$, represent the spacings between the contact points as indicated in FIG.2C, $y$ represents the distance between the contact points 20'-26' and the electrical boundary 34, $\Delta R_{BB'}$ represents the first resistance difference, $\Delta R_{CC'}$ represents the second resistance difference, $\Delta R_{AA'}$ represents the third resistance difference, $R_H$ represents the Hall sheet resistance at the position of the electrically conducting surface portion 32 where contact is established by the four-point probe 36. In FIG.5C the relation $f_1$ (Eq.2.7) is shown as a dash-dotted line, the relation $f_2$ (Eq.2.8) is shown as a dotted line, and the relation $f_3$ (Eq.2.9) is shown as a dashed line.

A first relation is then defined as:

$$f = \frac{f_1 + f_3}{f_2}, \qquad (Eq.2.10)$$

which can also be written as:

$$\frac{\Delta R_{AA'} + \alpha \cdot \Delta R_{CC'}}{\Delta R_{BB'}} = f(y,a,b,c), \qquad (Eq.2.11)$$

with $\alpha$ equal to 1, i.e. the first relation is a function of the distance $y$ and the spacings $a$, $b$, and $c$ between the contact points. This relation (Eq.2.10 and 2.11) is shown as a solid line in the graph of FIG.5C. The measured first ($\Delta R_{BB'}$), second ($\Delta R_{CC'}$), and third ($\Delta R_{AA'}$) resistance differences are then used with the first relation (Eq.2.11) to derive the normalized distance $3y/(a+b+c)$. For example, a ratio $(\Delta R_{AA} + \Delta R_{CC})/\Delta R_{BB}$ of 0.2 would give a normalized distance $3y/(a+b+c)$ of approximately 0.5, and a ratio $\Delta R_{CC'}/\Delta R_{BB}$ of 0.8 would give a normalized distance $3y/(a+b+c)$ of approximately 7, which can be read from FIG.5C. The nominal spacings $a, b,$ and $c$ are known and the distance y is therefore readily determined from the normalized distance $3y/(a+b+c)$. For example, with the spacing of FIG.2C, i.e. a = b = 14 $\mu$m and c = 35 $\mu$m, a normalized distance $3y/(a+b+c)$ of 0.5 would give a distance $y$ of approximately 10.5 $\mu$m, and a normalized distance $3y/(a+b+c)$ of 7 would give a distance y of approximately 147 $\mu$m. Further, a normalized distance $3y/(a+b+c)$ of 0.5 would give a value of the function $f_2$ of approximately 1.33, and a normalized distance $3y/(a+b+c)$ of 7 would give a value of the function $f_2$ of approximately 0.04. The measured first resistance difference ($\Delta R_{BB'}$) together with the relation in Eq.2.8 then gives the Hall sheet resistance $R_H$. The functions $f_1$ and $f_3$ can also be used in a similar fashion.

In order to determine the Sheet resistance of the electrically conductive surface portion, the pseudo sheet resistance $R_p$ is first determined from the van der Pauw equation:

$$\exp\left(\frac{2\pi\overline{R_{AA'}}}{R_P}\right) - \exp\left(\frac{2\pi\overline{R_{BB'}}}{R_P}\right) = 1, \qquad (Eq.2.12)$$

Another second relation is then defined for determining the sheet resistance of the electrically conducting surface portion where it is contacted by the four-point probe, namely:

$$\frac{R_P}{R_0} = g(y, a, b, c),$$ (Eq.2.13)

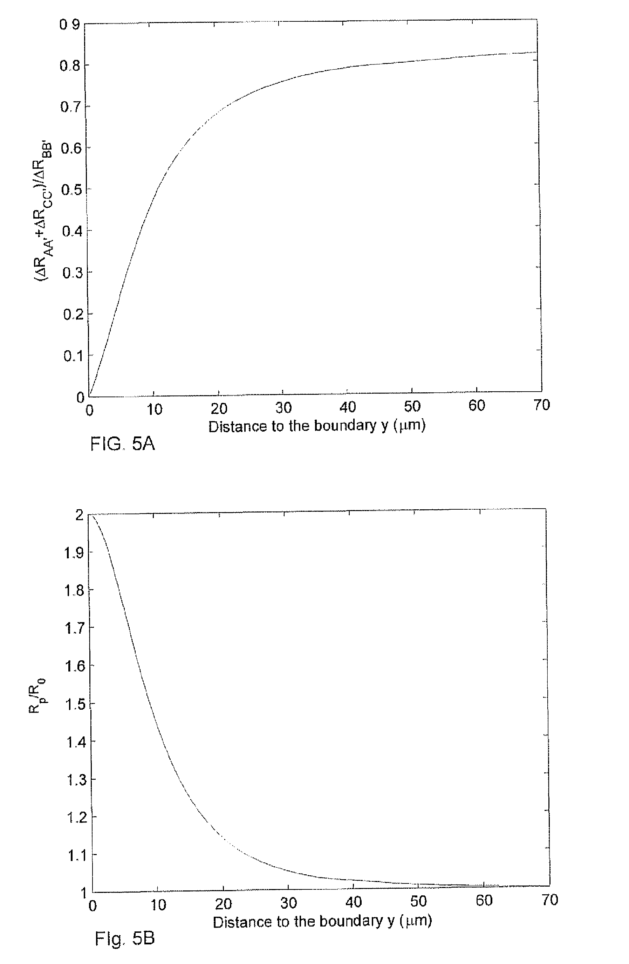

where $R_p$ is the pseudo sheet resistance, $R_o$ the sheet resistance, and $g$ is a function of the normalized distance $y$ and the spacings $a$, $b$, and $c$ between the contact points. The function g representing a four-point probe with asymmetric spacing contact probes as in FIG.2C is shown in FIG.5B. For example, distance $y$ of approximately 10.5 $\mu$m would give a value of the function $g$, or of the ration $R_p/R_0$, of approximately 1.44. With the pseudo sheet resistance $R_p$ determined as described in relation to Eq.2.12, the sheet resistance $R_0$ is then readily calculated from Eq.2.13.

A more general example for the determination of the Hall sheet resistance and the sheet resistance with a symmetric probe is given here. For a symmetric four-point probe with equidistant contact points. i.e. a=b=c=s, only four measurement configurations B, B', C and C' as shown in FIGS.3B(1), 3B(2), 3C(1), and 3C(2) giving the resistance values $R_B$, $R_{B'}$, $R_C$, and $R_{C'}$, respectively, are needed in the data treatment. The following is derived from the resistance values:

$$\Delta R_{BB'} = R_B - R_{B'}, \quad \overline{R_{BB'}} = (R_B + R_{B'})/2, \text{ and}$$ (3.1)

$$\Delta R_{CC'} = R_C - R_{C'}, \quad \overline{R_{CC'}} = (R_C + R_{C'})/2$$ (3.2)

With the averages, a pseudo sheet resistance $R_P$ is calculated from the van der Pauw equation:

$$\overline{R_{AA'}} = \overline{R_{BB'}} + \overline{R_{CC'}}, \text{ and}$$ (3.3)

$$\exp\left(\frac{2\pi \overline{R_{AA'}}}{R_P}\right) - \exp\left(\frac{2\pi \overline{R_{BB'}}}{R_P}\right) = 1$$ (3.4)

The resistance differences $\Delta R_{BB'}$ and $\Delta R_{CC'}$ are expressed with known functions as:

$$\Delta R_{BB'} = R_H \; f_1(\frac{y}{s}), \text{ and}$$ (3.5)

$$\Delta R_{CC'} = R_H \; f_2(\frac{y}{s})$$

$$(3.6)$$

Therefore, the ratio of $\Delta R_{BB'}$ and $\Delta R_{CC'}$ can be expressed as a function of $y$:

$$\frac{\Delta R_{CC'}}{\Delta R_{BB'}} = f(\frac{y}{s})$$

$$(3.7)$$

In this equation, the function $f$ can be obtained either with theoretical calculation or with numerical simulation, as is plotted in FIG.4A. With this plot, the distance $y$ is determined, and the Hall sheet resistance $R_H$ is then solved from either Eq.3.5 or Eq.3.6.

The ratio of the pseudo sheet resistance $R_P$ and the sheet resistance $R_0$ could also be expressed as a known function $g$ that is only dependant on $y/s$:

$$\frac{R_P}{R_0} = g(\frac{y}{s})$$

$$(3.8)$$

The function $g$ can be found either with theoretical calculation or with numerical simulation, and is plotted in Fig.4B. Finally, with this plot and the pseudo sheet resistance $R_P$ from Eq.3.4, the sheet resistance $R_0$ is calculated.

A more general example for the determination of the Hall sheet resistance and the sheet resistance with an asymmetric probe is given here. For an asymmetric four-point probe with the spacings a, b, and c, between the contact points of the contact elements, all the six configurations A, A', B, B', C and C' as shown in FIGS.3A(1), 3A(2), 3B(1), 3B(2), 3C(1), and 3C(2) giving the resistance values $R_A$, $R_A$, $R_B$, $R_{B'}$, $R_C$, and $R_{C'}$, respectively, are needed in the data treatment. Only five of the configurations are independent. Spacings of a=14um, b=14um, and c=35um, as is in FIG. 2C, are used in the following example, where the following is derived from the resistance values:

$$\Delta R_{AA'} = R_A - R_{A'}, \quad \overline{R_{AA'}} = (R_A + R_{A'})/2,$$

$$(4.1)$$

$$\Delta R_{BB'} = R_B - R_{B'}, \quad \overline{R_{BB'}} = (R_B + R_{B'})/2, \text{ and}$$

$$(4.2)$$

$$\Delta R_{CC'} = R_C - R_{C'}, \quad \overline{R_{CC'}} = (R_C + R_{C'})/2.$$

$$(4.3)$$

With the averages, a pseudo sheet resistance $R_P$ is calculated from the van der Pauw equation:

$$\exp\left(\frac{2\pi \overline{R_{AA'}}}{R_P}\right) - \exp\left(\frac{2\pi \overline{R_{BB'}}}{R_P}\right) = 1 \qquad (4.4)$$

The resistance differences $\Delta R_{AA'}$, $\Delta R_{BB'}$ and $\Delta R_{CC'}$ are expressed with known functions as:

$$\Delta R_{AA'} = R_H \, f_1(y,a,b,c) , \qquad (4.5)$$

$$\Delta R_{BB'} = R_H \, f_2(y,a,b,c) , \text{ and} \qquad (4.6)$$

$$\Delta R_{CC'} = R_H \, f_3(y,a,b,c) . \qquad (4.7)$$

Therefore, we can define a function of $\Delta R_{AA'}$, $\Delta R_{BB'}$ and $\Delta R_{CC'}$, which is only dependent on the distance $y$:

$$\frac{\Delta R_{AA'} + \alpha \cdot \Delta R_{CC'}}{\Delta R_{BB'}} = f(y,a,b,c) \qquad (4.8)$$

In this equation, the function $f$ can be obtained either with theoretical calculation or with numerical simulation. By tuning the factor $\alpha$, the function $f$ is optimized so that the distance detection could be less sensitive to the probe position errors. When a=14 $\mu$m, b=14 $\mu$m, and c=35 $\mu$m, it has been found that $\alpha$=1 is a good choice, and the function f can be plotted as is shown in FIG.5A. With this plot, the distance $y$ is determined, and the Hall sheet resistance $R_H$ is then solved from either of Eq.4.5, Eq.4.6, or Eq.4.7.
The ratio of the pseudo sheet resistance $R_P$ and the sheet resistance $R_0$ could also be expressed as a known function $g$:

$$\frac{R_P}{R_0} = g(y,a,b,c) \qquad (4.9)$$

The function g can be found either with theoretical calculation or with numerical simulation, and is plotted in FIG.5B. Finally, with this plot and the pseudo sheet resistance $R_P$ from Eq.4.4, the sheet resistance $R_0$ is calculated.
Points characterizing the invention:

1. A method for determining a distance between a first position on an electrically conducting surface portion of a test sample and an electrical boundary of said electrically conducting surface portion by a multi-point probe comprising a first contact element, a second contact element, a third contact element, and a fourth contact element, each contact element defining a contact point for establishing an electrical contact with said test sample, said method comprising:

(i) contacting said test sample with said first contact element, said second contact element, said third contact element, and said fourth contact element at said first position on said electrically conducting surface portion,

(ii) applying a magnetic field having a major field component perpendicular to said electrically conducting surface portion at said first position

(iii) applying a first electrical potential across said first and third contact elements for generating a first current in said surface portion at said first position,

(iv) measuring said first current through said first or said third contact element,

(v) measuring a first voltage across said second and fourth contact elements,

(vi) calculating a first resistance value $(R_B)$ based on said first current and said first voltage,

(vii) applying a second electrical potential across said second and fourth contact elements for generating a second current in said surface portion at said first position,

(viii) measuring said second current through said second or said fourth contact element,

(ix) measuring a second voltage across said first and third contact elements,

(x) calculating a second resistance value $(R_B')$ based on said second current and said second voltage,

(xi) calculating a first resistance difference $(\Delta R_{BB'})$ based on the difference between said first resistance value and said second resistance value,

(xii) applying a third electrical potential across said first and second contact elements for generating a third current in said surface portion at said first position,

(xiii) measuring said third current through said first or said second contact element,

(xiv) measuring a third voltage across said third and fourth contact elements,

(xv) calculating a third resistance value $(R_C)$ based on said third current and said third voltage,

(xvi) applying a fourth electrical potential across said third and fourth contact elements for generating a fourth current in said surface portion at said first position,

(xvii) measuring said fourth current through said third or said fourth contact element,

(xviii) measuring a fourth voltage across said first and second contact elements,

(xix) calculating a fourth resistance value $(R_C)$ based on said fourth current and said fourth voltage,

(xx) calculating a second resistance difference $(\Delta R_{CC'})$ based on the difference between said third resistance value and said fourth resistance value,

(xxi) defining a first relation $(f)$ including a first, a second, and a third parameter representing said first resistance difference, said second resistance difference, and said distance between said first position and said electrical boundary, respectively,

(xxii) determining said distance $(y)$ between said first position and said electrical boundary by using said first and said second resistance differences $(\Delta R_{BB'}, \Delta R_{CC'})$ as said first and said second parameter, respectively, in said first relation.

2. The method according to point 1 characterized by said contact points defining a first line intersecting each of said contact points.

3. The method according to point 2 characterized by said electrical boundary having an approximately linear portion and the distance between said first position and a point on said linear portion being smaller than the distance between said first position and any point on said electrical boundary outside said linear portion.

4. The method according to point 3 characterized by further comprising:

(xxxiv) orienting said multi-point probe to position said first line in a parallel relationship with said linear portion.

5. The method according to any of the points 1 to 4 characterized by the spacing between said contact points of said first and second contact elements, said second and third contact elements, and said third and fourth contact elements being approximately equal.

6. The method according to any of the points 1 to 5 characterized by said first relation being equivalent to $\Delta R_{CC'}/\Delta R_{BB'} = f(y,s)$, where $\Delta R_{BB'}$ represents said first resistance difference, $\Delta R_{CC'}$ represents said second resistance difference, and *f* is a function including said distance *y* between said first position and said electrical boundary and said spacing *s* between said contact points as parameters.

7. The method according to point 6 characterized by the first resistance difference $\Delta R_{BB'}$ in the relation $\Delta R_{CC'}/\Delta R_{BB'}$ = f(y,s) being equivalent to $\Delta R_{BB'} = 2R_H/\pi^*(\arctan(a/2y) + \arctan(b/2y) + \arctan(c/2y) - \arctan((a+b+c)/2y))$, where $\Delta R_{BB'}$ represents said additional first difference ($\Delta R_{BB'}$), *y* represents said distance (*y*), a represents the spacing between the contact points of said first and second contact elements, *b* represents the spacing between the contact points of said second and third contact elements, and c represents the spacing between the contact points of said third and fourth contact elements; and said second resistance difference $\Delta R_{CC'}$ in the relation $\Delta R_{CC'}/\Delta R_{BB'} = f(y,s)$ being equivalent to $\Delta R_{CC'} = 2R_H/\pi^*(\arctan((a+b+c)/2y) + \arctan(b/2y) - \arctan((a+b)/2y) - \arctan((b+c)/2y))$ where $\Delta R_{CC'}$ represents said additional second difference ($\Delta R_{CC}$), *y* represents said distance (*y*), a represents the spacing between the contact points of said first and second contact elements, *b* represents the spacing between the contact points of said second and third contact elements, and *c* represents the spacing between the contact points of said third and fourth contact elements.

8. The method according to any of the points 1 to 4 characterized by further comprising:

(xxiii) applying a fifth electrical potential across said first and fourth contact elements for generating a fifth current in said surface portion at said first position, (xxiv) measuring said fifth current through said first or said fourth contact element,
(xxv) measuring a fifth voltage across said second and third contact elements,
(xxvi) calculating a fifth resistance value ($R_A$) based on said fifth current and said fifth voltage,
(xxvii) applying a sixth electrical potential across said second and third contact elements for generating a sixth current in said surface portion at said first position, (xxviii) measuring said sixth current through said second or said third contact element,
(xxix) measuring a sixth voltage across said first and fourth contact elements, (xxx) calculating a sixth resistance value ($R_{A'}$) based on said sixth current and said sixth voltage,
(xxxi) calculating a third resistance difference ($\Delta R_{AA'}$) based on the difference between said fifth resistance value and said sixth resistance value,
(xxxii) in defining said first relation (*f*) said first relation (*f*) further includes a fourth parameter representing said third resistance difference ($\Delta R_{AA'}$), and
(xxxiii) in determining said distance (*y*) between said first position and said electrical boundary, said third resistance difference ($\Delta R_{AA'}$) is used as said fourth parameter in said first relation in addition to said first and said second resistance differences ($\Delta R_{BB'}$, $\Delta R_{CC'}$) being used as said first and said second parameter, respectively.

9. The method according to point 8 characterized by said contact points being positioned in-line and the spacing between said contact points of said first and second contact elements and the spacing between said contact points of said second and third contact elements being approximately equal..

10. The method according to any of the points 8 to 9 characterized by said contact points being positioned in-line and the spacing between said contact points of said third and fourth contact elements being different from the spacing between said contact points of said first and second contact.

11. The method according to point 10 characterized by the spacing between said contact points of said third and fourth contact element being greater than the spacing between said contact points of said first and second contact element by a factor in one or more of the ranges 1.1-3.7, 1.2-3.3, 1 3-2.9, 1.4-2.5, 1.5-2.1, and 1.6-1.7, and/or in one of the ranges 1 2-1.3, 1.3-1.4, 1.4-1.5, 1.5-1.6, 1.6-1.7, 1.7-1.8, 1.8-1.9, 1.9-20, 2.0-2.2, 2.2-24, 2.4-26, 2.6-2,8, 2.8-3.0, 3.0-3.3, 3.3-3.6, 3.6-3.9, and/or approximately five divided by three, or by a factor in one or more of the ranges 1.2-3.8, 1.6-3.4, 1.8-3.2, 2.0-3.0, 2.2-2.8, and 2.4-2.6, and/or in one of the ranges 1.2-1.3, 1.3-1.4, 1.4-1.5, 1.5-1.6, 1.6-1.7, 1.7-1.8, 1.8-9.9, 1.9-2.0, 2.0-2.2, 2.2-2.4, 2.4-2.6, 2.6-2.8, 2.8-3.0, 3.0-3.3, 3.3-3.6, 3.6-3.9, and/or approximately five divided by two.

12. The method according to any of the points 8 to 11 characterized by the spacing between said contact points of said first and second contact elements being in one of the ranges 1-5 $\mu$, 5-10 $\mu$m, 10-15 $\mu$m, 15-20 $\mu$m, 20-25 $\mu$m, 25-30 $\mu$m, 30-40 $\mu$m, 40-50 $\mu$m, 50-500 $\mu$m, and/or in one or more of the ranges 1-50 $\mu$m, 5-40 $\mu$m, 10-30 $\mu$m, 15-25 $\mu$m.

13. The method according to any of the points 8 to 12 characterized by said first relation being equivalent to ($\Delta R_{AA'}$+

$\alpha\Delta R_{CC'})/\Delta R_{BB'} = f(y,a,b,c)$, where $\Delta R_{BB'}$ is said first resistance difference, $\Delta R_{CC'}$ is said second resistance difference, $\Delta R_{AA'}$ is said third resistance difference, $\alpha$ is a tuning factor in the range -10 to 10; and f is a function including said distance $y$ between said first position and said electrical boundary and a said spacing between said contact points of said first and second contact elements, $b$ said spacing between said contact points of said second and third contact elements, and $c$ said spacing between said contact points of said third and fourth contact elements.

14. The method according to point 13 characterized by said tuning factor $\alpha$ being approximately 1 or approximately -1.

15. The method according to any of the points 13 to 14 characterized by the first resistance difference $\Delta R_{BB'}$ in the relation $(AR_{AA'} + \alpha\Delta R_{CC'}/\Delta R_{BB'} = f(y,a,b,c)$ being equivalent to $\Delta R_{BB'} = 2R_H/\pi^*(\arctan(a/2y) + \arctan(b/2y) + \arctan(c/2y) - \arctan((a+b+c)/2y))$, where $\Delta R_{BB'}$ represents said additional first difference ($\Delta R_{AA'}$), $y$ represents said distance ($y$), a represents the spacing between the contact points of said first and second contact elements, $b$ represents the spacing between the contact points of said second and third contact elements, and $c$ represents the spacing between the contact points of said third and fourth contact elements; said second resistance difference $\Delta R_{CC'}$ in the relation $(\Delta R_{AA'} + \alpha\Delta R_{CC'})/\Delta R_{BB'} = f(y,a,b,c)$ being equivalent to $\Delta R_{CC'} = 2R_H/\pi^*(\arctan((a+b+c)/2y) + \arctan(b/2y) - \arctan((a+b)/2y) - \arctan((b+c)/2y))$, where $\Delta R_{CC'}$ represents said additional second difference ($\Delta R_{CC'}$), $y$ represents said distance ($y$), a represents the spacing between the contact points of said first and second contact elements, b represents the spacing between the contact points of said second and third contact elements, and c represents the spacing between the contact points of said third and fourth contact elements; and said third resistance difference $\Delta R_{AA'}$ in the relation $(\Delta R_{AA'} + \alpha\Delta R_{CC'})/\Delta R_{BB'} = f(y,a,b,c)$ being equivalent to $\Delta R_{AA'} = 2R_H/\pi^*(\arctan((a+b)/2y) - \arctan(a/2y) - \arctan((b+c)/2y) + \arctan(c/2y))$, where $\Delta R_{AA'}$ represents said additional third resistance difference ($\Delta R_{AA'}$), $y$ represents said distance ($y$), a represents the spacing between the contact points of said first and second contact elements, $b$ represents the spacing between the contact points of said second and third contact elements, and $c$ represents the spacing between the contact points of said third and fourth contact elements.

16. The method according to any of the points 1 to 1 a characterized by said spacing between said contact points of said first and second contact elements being in one or more of the ranges 0.1-100 $\mu$m, 1-90 $\mu$m, 10-80 $\mu$m, 20-70 $\mu$m, 30-60 $\mu$m, and 40-50 $\mu$m, and/or in one of the ranges 0.1-1 $\mu$m, 1-10 $\mu$m, 10-20 $\mu$m, 20-30 $\mu$m, 30-40 $\mu$m, 40-50 $\mu$m, 50-60 $\mu$m, 60-70 $\mu$m, 70-80 $\mu$m, 80-90 $\mu$m, 90-100 $\mu$m, or 100-500$\mu$m.

17. A method for determining an electrical property at a first position on an electrically conducting surface portion of a test sample, said electrically conducting surface portion having an electrical boundary and said method comprising:

(a) determining a distance ($y$) between said first position on said electrically conducting surface portion of said test sample and said electrical boundary of said electrically conducting surface portion according to any of the points 1 to 16,
(b) defining a second relation including said electrical property and a fifth parameter representing said distance ($y$), and
(c) determining said electrical property from said second relation by using said distance (y) as said fifth parameter.

18. The method according to point 17 characterized by said second relation further including said spacing between the contact points of said first contact element, said second contact element, said third contact element, and/or said fourth contact element, and:

(b') in defining said second relation, said second relation further includes a ninth parameter representing the spacing between the contact points of said first contact element, said second contact element, said third contact element, and/or said fourth contact element, and
(c') in determining said electrical property, said spacing is used as said ninth parameter in said second relation in addition to said first distance (y).

19. The method according to any of the points 17 to 18 characterized by said electrical property being the Hall sheet resistance ($R_H$) and said second relation ($f_1,f_2$) further including a sixth parameter representing an additional first resistance difference ($\Delta R_{BB'}$), said method further comprising:

(d) applying an additional first electrical potential across said first and third contact elements for generating an additional first current in said surface portion at said first position,
(e) measuring said additional first current through said first or said third contact element,

(f) measuring an additional first voltage across said second and fourth contact elements,

(g) calculating an additional first resistance value $(R_B)$ based on said additional first current and said additional first voltage, or

(g') retaining said first resistance value $(R_B)$ from said determining of said distance as an additional first resistance value $(R_B)$, and

(h) applying an additional second electrical potential across said second and fourth contact elements for generating an additional second current in said surface portion at said first position,

(i) measuring said additional second current through said second or said fourth contact element,

(j) measuring an additional second voltage across said first and third contact elements,

(k) calculating an additional second resistance value $(R_{B'})$ based on said additional second current and said additional second voltage, or

(k') retaining said second resistance value $(R_{B'})$ from said determining of said distance as an additional second resistance value $(R_{B'})$, and

(l) calculating said additional first resistance difference $(\Delta R_{BB'})$ based on the difference between said additional first resistance value and said additional second resistance value, or

(l') retaining said first resistance difference $(\Delta R_{BB'})$ from said determining of said distance as said additional first resistance difference $(\Delta R_{BB'})$.

20. The method according to point 19 characterized by said second relation being equivalent to $\Delta R_{BB'} = 2R_H/\pi *$ (arctan($a/2y$) + arctan($b/2y$) + arctan($c/2y$) - arctan(($a+b+c$)/$2y$)) where $\Delta R_{BB'}$ represents said additional first difference $(AR_{BB'})$, $y$ represents said distance $(y)$, a represents the spacing between the contact points of said first and second contact elements, $b$ represents the spacing between the contact points of said second and third contact elements, and $c$ represents the spacing between the contact points of said third and fourth contact elements.

21. The method according to any of the points 17 to 18 characterized by said electrical property being the Hall sheet resistance $(R_H)$ and said second relation $(f_2, f_3)$ further including a sixth parameter representing an additional second resistance difference $(\Delta R_{CC})$, said method further comprising:

(d) applying an additional third electrical potential across said first and second contact elements for generating an additional third current in said surface portion at said first position,

(e) measuring said additional third current through said first or said second contact element,

(f) measuring an additional third voltage across said third and fourth contact elements,

(g) calculating an additional third resistance value $(R_C)$ based on said additional third current and said additional third voltage, or

(g') retaining said second resistance value $(R_C)$ from said determining of said distance as an additional first resistance value $(R_C)$, and

(h) applying an additional fourth electrical potential across said third and fourth contact elements for generating an additional fourth current in said surface portion at said first position,

(i) measuring said additional fourth current through said third or said fourth contact element,

(j) measuring an additional fourth voltage across said first and second contact elements,

(k) calculating an additional fourth resistance value $(R_{C'})$ based on said additional fourth current and said additional fourth voltage, or

(k') retaining said second resistance value $(R_{C'})$ from said determining of said distance as an additional first resistance value $(R_{C'})$, and

(l) calculating said additional second resistance difference $(\Delta R_{CC'})$ based on the difference between said additional third resistance value and said additional forth resistance value, or

(l') retaining said second resistance difference $(\Delta R_{CC'})$ from said determining of said distance as said additional second resistance difference $(\Delta R_{CC'})$.

22. The method according to point 21 characterized by said second relation being equivalent to $\Delta R_{CC'} = 2R_H/\pi *$ (arctan(($a+b+c$)/$2y$) + arctan($b/2y$) - arctan(($a+b$)/$2y$) - arctan(($b+c$)/$2y$)), where $\Delta R_{CC'}$ represents said additional second difference $(\Delta R_{CC'})$, $y$ represents said distance $(y)$, a represents the spacing between the contact points of said first and second contact elements, $b$ represents the spacing between the contact points of said second and third contact elements, and $c$ represents the spacing between the contact points of said third and fourth contact elements.

23. The method according to any of the points 17 to 18 characterized by said electrical property being the Hall sheet resistance $(R_H)$ and said second relation $(f_1)$ further including a sixth parameter representing an additional third

resistance difference ($\Delta R_{AA'}$), said method further comprising:

(d) applying an additional fifth electrical potential across said first and fourth contact elements for generating an additional fifth current in said surface portion at said first position,

(e) measuring said additional fifth current through said first or said fourth contact element,

(f) measuring an additional fifth voltage across said second and third contact elements,

(g) calculating an additional fifth resistance value ($R_A$) based on said additional fifth current and said additional fifth voltage, or

(g') retaining said fifth resistance value ($R_A$) from said determining of said distance as an additional fifth resistance value ($R_A$), and

(h) applying an additional sixth electrical potential across said second and third contact elements for generating an additional sixth current in said surface portion at said first position,

(i) measuring said additional sixth current through said second or said third contact element,

(j) measuring an additional sixth voltage across said first and fourth contact elements,

(k) calculating an additional sixth resistance value ($R_A$) based on said additional sixth current and said additional sixth voltage, or

(k') retaining said sixth resistance value ($R_{A'}$) from said determining of said distance as an additional fifth resistance value ($R_A$), and

(l) calculating said additional third resistance difference ($\Delta R_{AA'}$) based on the difference between said additional fifth resistance value and said additional sixth resistance value, or

(l') retaining said third resistance difference ($\Delta R_{AA'}$) from said determining of said distance as said additional third resistance difference ($\Delta R_{AA'}$).

24. The method according to point 23 characterized by said second relation being equivalent to $\Delta R_{AA'} = 2R_H/\pi *$ (arctan(($a+b$)/2$y$) - arctan($a$/2$y$) - arctan(($b+c$)/2$y$) + arctan($c$/2$y$)), where $\Delta R_{AA'}$ represents said additional third resistance difference ($\Delta R_{AA'}$), $y$ represents said distance ($y$), $a$ represents the spacing between the contact points of said first and second contact elements, $b$ represents the spacing between the contact points of said second and third contact elements, and $c$ represents the spacing between the contact points of said third and fourth contact elements.

25. The method according to any of the points 17 to 18 characterized by said electrical property being the sheet resistance ($R_0$) and said second relation ($g$) further including a sixth parameter representing a pseudo sheet resistance ($R_P$), said method further comprising:

(d) applying an additional fifth electrical potential across said first and fourth contact elements for generating an additional fifth current in said surface portion at said first position,

(e) measuring said additional fifth current through said first or said fourth contact element,

(f) measuring an additional fifth voltage across said second and third contact elements,

(g) calculating an additional fifth resistance value ($R_A$) based on said additional fifth current and said additional fifth voltage, or

(g') retaining said fifth resistance value ($R_A$) from said determining of said distance as an additional fifth resistance value ($R_A$), and

(h) applying an additional sixth electrical potential across said second and third contact elements for generating an additional sixth current in said surface portion at said first position,

(i) measuring said additional sixth current through said second or said third contact element,

(j) measuring an additional sixth voltage across said first and fourth contact elements,

(k) calculating an additional sixth resistance value ($R_{A'}$) based on said additional sixth current and said additional sixth voltage, or

(k') retaining said sixth resistance value ($R_{A'}$) from said determining of said distance as an additional fifth resistance value ($R_{A'}$), and

(l) calculating a first resistance mean ($\overline{R_{AA'}}$) of said additional fifth resistance value ($R_A$) and said additional sixth resistance value ($R_{A'}$), and

(d") applying an additional first electrical potential across said first and third contact elements for generating an additional first current in said surface portion at said first position,

(e") measuring said additional first current through said first or said third contact element,

(f") measuring an additional first voltage across said second and fourth contact elements,

(g") calculating an additional first resistance value ($R_B$) based on said additional first current and said additional first voltage, or

(g''') retaining said first resistance value ($R_B$) from said determining of said distance as an additional first resistance value ($R_B$), and

(h'') applying an additional second electrical potential across said second and fourth contact elements for generating an additional second current in said surface portion at said first position,

(i'') measuring said additional second current through said second or said fourth contact element,

(j'') measuring an additional second voltage across said first and third contact elements,

(k'') calculating an additional second resistance value ($R_{B'}$) based on said additional second current and said additional second voltage, or

(k''') retaining said second resistance value ($R_{B'}$) from said determining of said distance as an additional second resistance value ($R'_B$), and

(l'') calculating a second resistance mean ($\overline{R_{BB'}}$) of said additional first resistance value ($R_B$) and said additional second resistance value ($R_{B'}$), and

(m) defining a third relation including a seventh, eighth, and ninth parameter representing said first resistance mean ($\overline{R_{AA'}}$), said second resistance mean ($\overline{R_{BB'}}$), and said pseudo sheet resistance ($R_P$), respectively,

(n) determining said pseudo sheet resistance ($R_P$) by using said first resistance mean ($\overline{R_{AA'}}$) and said second resistance mean ($\overline{R_{BB'}}$) as said seventh parameter and said eighth parameter, respectively, in said third relation.

26. The method according to point 25 characterized by said third relation being equivalent to $\exp(2\pi \cdot \overline{R_{AA'}}/R_P) - \exp(2\pi \cdot \overline{R_{BB'}}/R_P) = 1$, where $R_P$ is said pseudo sheet resistance, $\overline{R_{AA'}}$ is said first resistance mean, and $\overline{R_{BB'}}$ is said second resistance mean.

27. An apparatus for determining a distance between a first position on an electrically conducting surface portion of a test sample and an electrical boundary of said electrically conducting surface portion, said apparatus comprising:

a multi-point probe comprising a first contact element, a second contact element, a third contact element, and a fourth contact element, each contact element defining a contact point for establishing an electrical contact with said test sample, and

a control unit adapted for performing the method for determining a distance according to any of the points 1 to 16.

28. An apparatus for determining an electrical property at a first position on an electrically conducting surface portion of a test sample comprising:

a multi-point probe comprising a first contact element, a second contact element, a third contact element, and a fourth contact element, each contact element defining a contact point for establishing an electrical contact with said test sample, and

a control unit adapted for performing the method for determining an electrical property at a first position on an electrically conducting surface portion of a test sample according to any of the points 17 to 26.

**ITEM LIST**

12    second contact element

14    third contact element

16    fourth contact element

18    probe body

20    contact point of the first contact element

22    contact point of the second contact element

24    contact point of the third contact element

26    contact point of the fourth contact element

30    test sample

32    surface portion

33    side surface

34    electrical boundary

36    multi-point probe

40    common line

42    linear portion

44    electrically non-conducting surface portion

**Claims**

1.  A method for determining a distance between a first position on an electrically conducting surface portion of a test sample and an electrical boundary of said electrically conducting surface portion by a multi-point probe comprising a first contact element, a second contact element, a third contact element, and a fourth contact element, each contact element defining a contact point for establishing an electrical contact with said test sample, said method comprising:

    (i) contacting said test sample with said first contact element, said second contact element, said third contact element, and said fourth contact element at said first position on said electrically conducting surface portion,
    (ii) applying a magnetic field having a major field component perpendicular to said electrically conducting surface portion at said first position,
    (iii) applying a first electrical potential across said first and third contact elements for generating a first current in said surface portion at said first position,
    (iv) measuring said first current through said first or said third contact element,
    (v) measuring a first voltage across said second and fourth contact elements,
    (vi) calculating a first resistance value ($R_B$) based on said first current and said first voltage,
    (vii) applying a second electrical potential across said second and fourth contact elements for generating a second current in said surface portion at said first position,
    (viii) measuring said second current through said second or said fourth contact element,
    (ix) measuring a second voltage across said first and third contact elements,
    (x) calculating a second resistance value ($R_{B'}$) based on said second current and said second voltage,
    (xi) calculating a first resistance difference ($\Delta R_{BB'}$) based on the difference between said first resistance value and said second resistance value,
    (xii) applying a third electrical potential across said first and second contact elements for generating a third current in said surface portion at said first position,
    (xiii) measuring said third current through said first or said second contact element,
    (xiv) measuring a third voltage across said third and fourth contact elements, (xv) calculating a third resistance value ($R_C$) based on said third current and said third voltage,
    (xvi) applying a fourth electrical potential across said third and fourth contact elements for generating a fourth current in said surface portion at said first position,
    (xvii) measuring said fourth current through said third or said fourth contact element,
    (xviii) measuring a fourth voltage across said first and second contact elements,
    (xix) calculating a fourth resistance value ($R_{C'}$) based on said fourth current and said fourth voltage,
    (xx) calculating a second resistance difference ($\Delta R_{CC'}$) based on the difference between said third resistance value and said forth resistance value,
    (xxi) defining a first relation ($f$) including a first, a second, and a third parameter representing said first resistance difference, said second resistance difference, and said distance between said first position and said electrical boundary, respectively,
    (xxii) determining said distance ($y$) between said first position and said electrical boundary by using said first and said second resistance differences ($\Delta R_{BB'}$, $\Delta R_{CC'}$) as said first and said second parameter, respectively, in said first relation.

2. The method according to claim 1 **characterized by** said first relation being equivalent to $\Delta R_{CC'}/\Delta_{BB'} = f(y,s)$, where $\Delta R_{BB'}$ represents said first resistance difference, $\Delta R_{CC'}$ represents said second resistance difference, and $f$ is a function including said distance $y$ between said first position and said electrical boundary and said spacing s between said contact points as parameters.

3. The method according to claim 2 **characterized by** the first resistance difference $\Delta R_{BB'}$ in the relation $\Delta R_{CC'}/\Delta R_{BB'} = f(y,s)$ being equivalent to $\Delta R_{BB'} = 2R_H/\pi^*(\arctan(a/2y) + \arctan(b/2y) + \arctan(c/2y) - \arctan((a+b+c)/2y))$, where $\Delta R_{BB'}$ represents said additional first difference ($\Delta R_{BB'}$), $y$ represents said distance ($y$), a represents the spacing between the contact points of said first and second contact elements, $b$ represents the spacing between the contact points of said second and third contact elements, and $c$ represents the spacing between the contact points of said third and fourth contact elements; and said second resistance difference $\Delta R_{CC'}$ in the relation $\Delta R_{CC'}/\Delta R_{BB'} = f(y,s)$ being equivalent to $\Delta R_{CC'} = 2R_H/\pi^*(\arctan((a+b+c)/2y) + \arctan(b/2y) - \arctan((a+b)/2y) - \arctan((b+c)/2y))$ where $\Delta R_{CC'}$ represents said additional second difference ($\Delta R_{CC'}$), $y$ represents said distance ($y$), a represents the spacing between the contact points of said first and second contact elements, $b$ represents the spacing between the contact points of said second and third contact elements, and $c$ represents the spacing between the contact points of said third and fourth contact elements.

4. The method according to any of the claims 1 to 3 **characterized by** further comprising:

   (xxiii) applying a fifth electrical potential across said first and fourth contact elements for generating a fifth current in said surface portion at said first position, (xxiv) measuring said fifth current through said first or said fourth contact element,
   (xxv) measuring a fifth voltage across said second and third contact elements,
   (xxvi) calculating a fifth resistance value ($R_A$) based on said fifth current and said fifth voltage,
   (xxvii) applying a sixth electrical potential across said second and third contact elements for generating a sixth current in said surface portion at said first position, (xxviii) measuring said sixth current through said second or said third contact element,
   (xxix) measuring a sixth voltage across said first and fourth contact elements, (xxx) calculating a sixth resistance value ($R_A$) based on said sixth current and said sixth voltage,
   (xxxi) calculating a third resistance difference ($\Delta R_{AA'}$) based on the difference between said fifth resistance value and said sixth resistance value,
   (xxxii) in defining said first relation ($f$) said first relation ($f$) further includes a fourth parameter representing said third resistance difference ($\Delta R_{AA}$), and
   (xxxiii) in determining said distance ($y$) between said first position and said electrical boundary, said third resistance difference ($\Delta R_{AA'}$) is used as said fourth parameter in said first relation in addition to said first and said second resistance differences ($\Delta R_{BB'}, \Delta R_{CC'}$) being used as said first and said second parameter, respectively

5. The method according to claim 4 **characterized by** said contact points being positioned in-line and the spacing between said contact points of said third and fourth contact elements being different from the spacing between said contact points of said first and second contact.

6. The method according to any of the claim 4 to 5 **characterized by** said first relation being equivalent to $(\Delta R_{AA'} + \alpha \Delta R_{CC'})/\Delta R_{BB'} = f(y,a,b,c)$, where $\Delta R_{BB'}$ is said first resistance difference, $\Delta R_{CC'}$ is said second resistance difference, $\Delta R_{AA'}$ is said third resistance difference, $\alpha$ is a tuning factor in the range -10 to 10; and f is a function including said distance $y$ between said first position and said electrical boundary, and a said spacing between said contact points of said first and second contact elements, $b$ said spacing between said contact points of said second and third contact elements, and $c$ said spacing between said contact points of said third and fourth contact elements.

7. The method according to claim 6 **characterized by** the first resistance difference $\Delta R_{BB'}$ in the relation $(\Delta R_{AA'} + \alpha \Delta R_{CC'})/\Delta R_{BB'} = f(y,a,b,c)$ being equivalent to $\Delta R_{BB'} = 2R_H/\Pi^*(\arctan(a/2y) + \arctan(b/2y) + \arctan(c/2y) - \arctan((a+b+c)/2y))$, where $\Delta R_{BB'}$, represents said additional first difference ($\Delta R_{AA'}$), $y$ represents said distance ($y$), a represents the spacing between the contact points of said first and second contact elements, $b$ represents the spacing between the contact points of said second and third contact elements, and $c$ represents the spacing between the contact points of said third and fourth contact elements; said second resistance difference $\Delta R_{CC'}$ in the relation $(\Delta R_{AA'} + \alpha \Delta R_{CC'})/\Delta R_{BB'} = f(y,a,b,c)$ being equivalent to $\Delta R_{CC'} = 2R_H/\pi^*(\arctan((a+b+c)/2y) + \arctan(b/2y) - \arctan((a+b)/2y) - \arctan((b+c)/2y))$, where $\Delta R_{CC}$ represents said additional second difference ($\Delta R_{CC'}$), $y$ represents said distance ($y$), $a$ represents the spacing between the contact points of said first and second contact elements, $b$ represents the spacing between the contact points of said second and third contact elements, and $c$ represents the spacing between the contact points of said third and fourth contact elements; and said third resistance difference $\Delta R_{AA'}$ in the relation $(\Delta R_{AA'} + \alpha\Delta R_{CC'})/\Delta R_{BB'} = f(y,a,b,c)$ being equivalent to $\Delta R_{AA'} = 2R_H/\pi^*(\arctan((a+b)/2y) - \arctan(a/2y) - \arctan((b+c)/2y) + \arctan(c/2y))$, where $\Delta R_{AA'}$ represents said additional third resistance difference ($\Delta R_{AA'}$), $y$ represents said distance ($y$), $a$ represents the spacing between the contact points of said first and second contact elements, $b$ represents the spacing between the contact points of said second and third contact elements, and $c$ represents the spacing between the contact points of said third and fourth contact elements.

8. A method for determining an electrical property at a first position on an electrically conducting surface portion of a test sample, said electrically conducting surface portion having an electrical boundary and said method comprising:

   (a) determining a distance ($y$) between said first position on said electrically conducting surface portion of said test sample and said electrical boundary of said electrically conducting surface portion according to any of the claims 1 to 7,
   (b) defining a second relation including said electrical property and a fifth parameter representing said distance ($y$), and
   (c) determining said electrical property from said second relation by using said distance (y) as said fifth parameter.

9. The method according to claim 8 **characterized by** said second relation further including said spacing between the contact points of said first contact element, said second contact element, said third contact element, and/or said fourth contact element, and:

   (b') in defining said second relation, said second relation further includes a ninth parameter representing the spacing between the contact points of said first contact element, said second contact element, said third contact element, and/or said fourth contact element, and
   (c') in determining said electrical property, said spacing is used as said ninth parameter in said second relation in addition to said first distance (y)

10. The method according to any of the claims 8 to 9 **characterized by** said electrical property being the Hall sheet resistance ($R_H$) and said second relation ($f_1,f_2$) further including a sixth parameter representing an additional first resistance difference ($\Delta R_{BB'}$), said method further comprising:

    (d) applying an additional first electrical potential across said first and third contact elements for generating an additional first current in said surface portion at said first position,
    (e) measuring said additional first current through said first or said third contact element,
    (f) measuring an additional first voltage across said second and fourth contact elements,
    (g) calculating an additional first resistance value ($R_B$) based on said additional first current and said additional first voltage, or
    (g') retaining said first resistance value ($R_B$) from said determining of said distance as an additional first resistance value ($R_B$), and
    (h) applying an additional second electrical potential across said second and fourth contact elements for generating an additional second current in said surface portion at said first position,
    (i) measuring said additional second current through said second or said fourth contact element,
    (j) measuring an additional second voltage across said first and third contact elements,
    (k) calculating an additional second resistance value ($R_{B'}$) based on said additional second current and said additional second voltage, or
    (k') retaining said second resistance value ($R_{B'}$) from said determining of said distance as an additional second resistance value ($R_{B'}$), and
    (l) calculating said additional first resistance difference ($\Delta R_{BB'}$) based on the difference between said additional first resistance value and said additional second resistance value, or
    (l') retaining said first resistance difference ($\Delta R_{BB'}$) from said determining of said distance as said additional first resistance difference ($\Delta R_{BB'}$).

11. The method according to any of the claims 8 to 9 **characterized by** said electrical property being the Hall sheet resistance ($R_H$) and said second relation ($f_2,f_3$) further including a sixth parameter representing an additional second resistance difference ($\Delta R_{CC'}$), said method further comprising:

(d) applying an additional third electrical potential across said first and second contact elements for generating an additional third current in said surface portion at said first position,

(e) measuring said additional third current through said first or said second contact element,

(f) measuring an additional third voltage across said third and fourth contact elements,

(g) calculating an additional third resistance value ($R_C$) based on said additional third current and said additional third voltage, or

(g') retaining said second resistance value ($R_C$) from said determining of said distance as an additional first resistance value ($R_C$), and

(h) applying an additional fourth electrical potential across said third and fourth contact elements for generating an additional fourth current in said surface portion at said first position,

(i) measuring said additional fourth current through said third or said fourth contact element,

(j) measuring an additional fourth voltage across said first and second contact elements,

(k) calculating an additional fourth resistance value ($R_{C'}$) based on said additional fourth current and said additional fourth voltage, or

(k') retaining said second resistance value ($R_{C'}$) from said determining of said distance as an additional first resistance value ($R_{C'}$), and

(l) calculating said additional second resistance difference ($\Delta R_{CC}$) based on the difference between said additional third resistance value and said additional forth resistance value, or

(l') retaining said second resistance difference ($\Delta R_{CC'}$) from said determining of said distance as said additional second resistance difference ($\Delta R_{CC'}$).

12. The method according to any of the claims 8 to 9 **characterized by** said electrical property being the Hall sheet resistance ($R_H$) and said second relation ($f_1$) further including a sixth parameter representing an additional third resistance difference ($\Delta R_{AA'}$), said method further comprising:

(d) applying an additional fifth electrical potential across said first and fourth contact elements for generating an additional fifth current in said surface portion at said first position,

(e) measuring said additional fifth current through said first or said fourth contact element,

(f) measuring an additional fifth voltage across said second and third contact elements,

(g) calculating an additional fifth resistance value ($R_A$) based on said additional fifth current and said additional fifth voltage, or

(g') retaining said fifth resistance value ($R_A$) from said determining of said distance as an additional fifth resistance value ($R_A$), and

(h) applying an additional sixth electrical potential across said second and third contact elements for generating an additional sixth current in said surface portion at said first position,

(i) measuring said additional sixth current through said second or said third contact element,

(j) measuring an additional sixth voltage across said first and fourth contact elements,

(k) calculating an additional sixth resistance value ($R_{A'}$) based on said additional sixth current and said additional sixth voltage, or

(k') retaining said sixth resistance value ($R_{A'}$) from said determining of said distance as an additional fifth resistance value ($R_{A'}$), and

(l) calculating said additional third resistance difference ($\Delta R_{AA'}$) based on the difference between said additional fifth resistance value and said additional sixth resistance value, or

(l') retaining said third resistance difference ($\Delta R_{AA'}$) from said determining of said distance as said additional third resistance difference ($\Delta R_{AA'}$).

13. The method according to any of the claims 8 to 9 **characterized by** said electrical property being the sheet resistance ($R_0$) and said second relation ($g$) further including a sixth parameter representing a pseudo sheet resistance ($R_P$), said method further comprising:

(d) applying an additional fifth electrical potential across said first and fourth contact elements for generating an additional fifth current in said surface portion at said first position,

(e) measuring said additional fifth current through said first or said fourth contact element,

(f) measuring an additional fifth voltage across said second and third contact elements,

(g) calculating an additional fifth resistance value ($R_A$) based on said additional fifth current and said additional fifth voltage, or

(g') retaining said fifth resistance value ($R_A$) from said determining of said distance as an additional fifth resistance value ($R_A$), and

(h) applying an additional sixth electrical potential across said second and third contact elements for generating an additional sixth current in said surface portion at said first position,

(i) measuring said additional sixth current through said second or said third contact element,

(j) measuring an additional sixth voltage across said first and fourth contact elements,

(k) calculating an additional sixth resistance value ($R_{A'}$) based on said additional sixth current and said additional sixth voltage, or

(k') retaining said sixth resistance value ($R_{A'}$) from said determining of said distance as an additional fifth resistance value ($R_{A'}$), and

(l) calculating a first resistance mean ($\overline{R_{AA'}}$) of said additional fifth resistance value ($R_A$) and said additional sixth resistance value ($R_{A'}$), and

(d") applying an additional first electrical potential across said first and third contact elements for generating an additional first current in said surface portion at said first position,

(e") measuring said additional first current through said first or said third contact element,

(f") measuring an additional first voltage across said second and fourth contact elements,

(g") calculating an additional first resistance value ($R_B$) based on said additional first current and said additional first voltage, or

(g''') retaining said first resistance value ($R_B$) from said determining of said distance as an additional first resistance value ($R_B$), and

(h") applying an additional second electrical potential across said second and fourth contact elements for generating an additional second current in said surface portion at said first position,

(i") measuring said additional second current through said second or said fourth contact element,

(j") measuring an additional second voltage across said first and third contact elements,

(k") calculating an additional second resistance value ($R_{B'}$) based on said additional second current and said additional second voltage, or

(k''') retaining said second resistance value ($R_{B'}$) from said determining of said distance as an additional second resistance value ($R'_B$), and

(l") calculating a second resistance mean ($\overline{R_{BB'}}$) of said additional first resistance value ($R_B$) and said additional second resistance value ($R_{B'}$), and

(m) defining a third relation including a seventh, eighth, and ninth parameter representing said first resistance mean ($\overline{R_{AA'}}$), said second resistance mean ($\overline{R_{BB'}}$), and said a pseudo sheet resistance ($R_P$), respectively,

(n) determining said pseudo sheet resistance ($R_P$) by using said first resistance mean ($\overline{R_{AA'}}$) and said second resistance mean ($\overline{R_{BB'}}$) as said seventh parameter and said eighth parameter, respectively, in said third relation.

14. An apparatus for determining a distance between a first position on an electrically conducting surface portion of a test sample and an electrical boundary of said electrically conducting surface portion, said apparatus comprising:

a multi-point probe comprising a first contact element, a second contact element, a third contact element, and a fourth contact element, each contact element defining a contact point for establishing an electrical contact with said test sample, and

a control unit adapted for performing the method for determining a distance according to any of the claims 1 to 7.

15. An apparatus for determining an electrical property at a first position on an electrically conducting surface portion of a test sample comprising:

a multi-point probe comprising a first contact element, a second contact element, a third contact element, and a fourth contact element, each contact element defining a contact point for establishing an electrical contact with said test sample, and

a control unit adapted for performing the method for determining an electrical property at a first position on an electrically conducting surface portion of a test sample according to any of the claims 8 to 13.

FIG. 1

FIG. 2A

FIG. 2B

FIG. 2C

FIG.3A(1)

FIG.3A(2)

FIG.3B(1)

FIG.3B(2)

FIG.3C(1)

FIG.3C(2)

FIG. 4A

FIG. 4B

FIG. 4C

FIG. 5A

Fig. 5B

FIG. 5C

Europäisches
Patentamt

European
Patent Office

Office européen
des brevets

## EUROPEAN SEARCH REPORT

Application Number

EP 10 19 6137

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2009/030230 A1 (CAPRES AS [DK]; PETERSEN DIRCH HJORTH [DK]; HANSEN OLE [DK]) 12 March 2009 (2009-03-12)<br>* figures 5-9 *<br>* page 1, line 3 - page 8, line 12 *<br>* page 9, line 20 - line 35 *<br>* page 13, line 29 - page 17, line 20 * | 1,8,14, 15 | INV.<br>G01N27/04<br>G01R31/26<br>H01L21/66 |
| X | OSTERBERG F W ET AL: "Accurate micro Hall Effect measurements on scribe line pads", ADVANCED THERMAL PROCESSING OF SEMICONDUCTORS, 2009. RTP '09. 17TH INTERNATIONAL CONFERENCE ON, IEEE, PISCATAWAY, NJ, USA,<br>29 September 2009 (2009-09-29), pages 1-6, XP031595915,<br>ISBN: 978-1-4244-3814-3<br>* the whole document * | 1-15 | |
| X | PETERSEN DIRCH ET AL: "Micro-four-point probe Hall effect measurement method", JOURNAL OF APPLIED PHYSICS, AMERICAN INSTITUTE OF PHYSICS. NEW YORK, US,<br>vol. 104, no. 1, 11 July 2008 (2008-07-11) , pages 13710-13710, XP012116326,<br>ISSN: 0021-8979, DOI:<br>DOI:10.1063/1.2949401 | 14,15 | TECHNICAL FIELDS SEARCHED (IPC)<br><br>G01R<br>G01N<br>H01L |
| A | * the whole document * | 1-13 | |
| A | WO 2007/045246 A1 (CAPRES AS [DK]; HANSEN TORBEN MIKAEL [DK])<br>26 April 2007 (2007-04-26)<br>* figures 1-5 *<br>* page 8, line 8 - page 14, line 34 * | 1-15 | |

-/--

The present search report has been drawn up for all claims

| Place of search | Date of completion of the search | Examiner |
|---|---|---|
| Berlin | 8 June 2011 | Höller, Helmut |

EPO FORM 1503 03.82 (P04C01)

Europäisches
Patentamt

European
Patent Office

Office européen
des brevets

## EUROPEAN SEARCH REPORT

Application Number

EP 10 19 6137

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | US 5 150 042 A (LOOK DAVID C [US] ET AL)<br>22 September 1992 (1992-09-22)<br>* figures 1,3 *<br>* column 2, line 50 - column 4, line 16 *<br>----- | 14,15<br><br>1,8 | |
| A | CH 682 017 A5 (RADIVOJE POPOVIC)<br>30 June 1993 (1993-06-30)<br>* figures 1-3 *<br>* page 2, line 16 - line 21 *<br>* page 2, line 55 - page 8, line 3 *<br>----- | 1-15 | |
| X<br>A | US 2005/052191 A1 (PRUSSIN SIMON A [US])<br>10 March 2005 (2005-03-10)<br>* figures 1B,2 *<br>* paragraphs [0002], [0010], [0016] *<br>* paragraphs [0020], [0023] *<br>* paragraph [0047] - paragraph [0058] *<br>* paragraphs [0067], [0068] *<br>* paragraph [0102] - paragraph [0114] *<br>----- | 14,15<br><br>1-13 | |
| A | US 5 797 114 A (ROBERTS JOHN [GB] ET AL)<br>18 August 1998 (1998-08-18)<br>* figures 1-3,5 *<br>* column 4, line 26 - line 50 *<br>* column 6, line 9 - column 7, line 3 *<br>----- | 1,8,14,<br>15 | **TECHNICAL FIELDS SEARCHED (IPC)** |
| A | US 3 735 254 A (SEVERIN P)<br>22 May 1973 (1973-05-22)<br>* figures 1,4,5 *<br>* column 8, line 11 - column 10, line 58 *<br>-----<br>-/-- | 1,8,14,<br>15 | |

The present search report has been drawn up for all claims

| Place of search | Date of completion of the search | Examiner |
|---|---|---|
| Berlin | 8 June 2011 | Höller, Helmut |

EPO FORM 1503 03.82 (P04C01)

Europäisches
Patentamt

European
Patent Office

Office européen
des brevets

**EUROPEAN SEARCH REPORT**

Application Number

EP 10 19 6137

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | STOJANOVIC G ET AL: "Important Role of the Hall Effect Measurement System in a Modified Course of Materials in Electrical Engineering", IEEE TRANSACTIONS ON EDUCATION, IEEE SERVICE CENTER, PISCATAWAY, NJ, US, vol. 52, no. 3, 1 August 2009 (2009-08-01), pages 297-304, XP011268639, ISSN: 0018-9359, DOI: DOI:10.1109/TE.2008.928206 * page 300, left-hand column - right-hand column * ----- | 1,8,14, 15 | |
| A | US 4 857 839 A (LOOK DAVID C [US] ET AL) 15 August 1989 (1989-08-15) * figures 1,4,5,6 * * column 3, line 5 - column 8, line 59 * ----- | 1,8,14, 15 | |

TECHNICAL FIELDS
SEARCHED     (IPC)

The present search report has been drawn up for all claims

| Place of search | Date of completion of the search | Examiner |
|---|---|---|
| Berlin | 8 June 2011 | Höller, Helmut |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

.......................................................................

& : member of the same patent family, corresponding
document

# EP 2 469 271 A1

## ANNEX TO THE EUROPEAN SEARCH REPORT
## ON EUROPEAN PATENT APPLICATION NO.

EP 10 19 6137

This annex lists the patent family members relating to the patent documents cited in the above-mentioned European search report.
The members are as contained in the European Patent Office EDP file on
The European Patent Office is in no way liable for these particulars which are merely given for the purpose of information.

08-06-2011

| Patent document cited in search report | | Publication date | Patent family member(s) | | Publication date |
|---|---|---|---|---|---|
| WO 2009030230 | A1 | 12-03-2009 | CN 101821638 A | | 01-09-2010 |
| | | | EP 2198316 A1 | | 23-06-2010 |
| | | | JP 2010540890 T | | 24-12-2010 |
| | | | KR 20100049098 A | | 11-05-2010 |
| | | | US 2010271059 A1 | | 28-10-2010 |
| WO 2007045246 | A1 | 26-04-2007 | CN 101331403 A | | 24-12-2008 |
| | | | EP 1775594 A1 | | 18-04-2007 |
| | | | EP 1949115 A1 | | 30-07-2008 |
| | | | JP 2009511925 T | | 19-03-2009 |
| | | | KR 20080059308 A | | 26-06-2008 |
| | | | US 2008294365 A1 | | 27-11-2008 |
| | | | US 2011084706 A1 | | 14-04-2011 |
| US 5150042 | A | 22-09-1992 | NONE | | |
| CH 682017 | A5 | 30-06-1993 | NONE | | |
| US 2005052191 | A1 | 10-03-2005 | NONE | | |
| US 5797114 | A | 18-08-1998 | GB 2276462 A | | 28-09-1994 |
| | | | WO 9422027 A1 | | 29-09-1994 |
| | | | JP 8509840 T | | 15-10-1996 |
| US 3735254 | A | 22-05-1973 | BE 768158 A1 | | 06-12-1971 |
| | | | DE 2125456 A1 | | 16-12-1971 |
| | | | FR 2094093 A1 | | 04-02-1972 |
| | | | GB 1354777 A | | 05-06-1974 |
| | | | JP 52021351 B | | 09-06-1977 |
| | | | NL 7008274 A | | 08-12-1971 |
| US 4857839 | A | 15-08-1989 | NONE | | |

EPO FORM P0459

For more details about this annex : see Official Journal of the European Patent Office, No. 12/82

37

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2007045246 A1
- WO 2010115771 A1
- WO 2010000265 A1
- WO 2008110174 A1
- WO 2007051471 A1
- WO 05124371 A1
- WO 0003252 A2